(19) Europäisches Patentamt
European Patent Office
Office européen des brevets

(11) EP 4 654 089 A1

(12) EUROPEAN PATENT APPLICATION
published in accordance with Art. 153(4) EPC

(43) Date of publication:
26.11.2025 Bulletin 2025/48

(51) International Patent Classification (IPC):
G06N 10/40 (2022.01)

(21) Application number: 23917479.0

(22) Date of filing: 18.01.2023

(52) Cooperative Patent Classification (CPC):
G06N 10/40

(86) International application number:
PCT/JP2023/001369

(87) International publication number:
WO 2024/154266 (25.07.2024 Gazette 2024/30)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: FUJITSU LIMITED
Kawasaki-shi, Kanagawa 211-8588 (JP)

(72) Inventors:
• YAMAGUCHI, Jumpei
Kawasaki-shi, Kanagawa 211-8588 (JP)
• IZU, Tetsuya
Kawasaki-shi, Kanagawa 211-8588 (JP)

(74) Representative: Hoffmann Eitle
Patent- und Rechtsanwälte PartmbB
Arabellastraße 30
81925 München (DE)

(54) QUANTUM CIRCUIT DESIGN SUPPORT PROGRAM, QUANTUM CIRCUIT DESIGN SUPPORT METHOD, AND QUANTUM CIRCUIT DESIGN SUPPORT DEVICE

(57) The number of quantum gates is reduced in a quantum circuit.

A quantum circuit design support apparatus (10) determines the number of control qubits for each of one or more third quantum gates (3b) corresponding respectively to one or more third qubits (2c) that have a predetermined value before the gate operation of a first quantum gate (2) that flips the value of the target qubit when all control qubits are 1, and the number of control qubits for a second quantum gate (3a) so that a predetermined relationship is satisfied. The quantum circuit design support apparatus (10) generates a second quantum circuit (3) including the third quantum gates (3b), each using first qubits (2a) equal in number to the determined number of control qubits as the control qubits and a third qubit (2c) as the target qubit, and the second quantum gate (3a) using a first qubit (2a) not used in the third quantum gates (3b) and the third qubits (2c) as the control qubits and the second qubit (2b) as the target qubit.

FIG. 1

**Description**

Technical Field

The embodiments discussed herein relate to a quantum circuit design support program, a quantum circuit design support method, and a quantum circuit design support apparatus.

Background Art

Quantum computation that is executed by a quantum computer or a quantum computer simulator (hereinafter, quantum simulator) is represented by a quantum circuit. A quantum circuit is a quantum computation model in which various types of quantum gates are combined. A quantum gate represents an operation that modifies the state of a qubit. Quantum gates used in a quantum circuit include basic quantum gates and others. The basic quantum gates are quantum gates that are easily implemented on a quantum computer.

To create a quantum circuit, first, a quantum circuit representing a sequence of gate operations for solving a target problem is generated using a quantum circuit description language. The quantum circuit generated in the quantum circuit description language includes basic quantum gates, as well as other quantum gates that perform complex operations. Therefore, a classical computer converts the quantum gates other than the basic quantum data in the quantum circuit into equivalent quantum circuits (equivalent circuits) in which basic quantum gates are combined. As a result, a quantum circuit defined using only basic quantum gates is generated.

Converting the quantum gates other than the basic quantum gates into equivalent circuits in which basic quantum gates are combined increases the number of quantum gates. As the number of quantum gates in a quantum circuit increases, the efficiency of quantum computation performed by a quantum computer or a quantum simulator decreases. In addition, in quantum computers, qubits are able to maintain their quantum states only for a limited duration. Therefore, a smaller number of basic quantum gates in a quantum circuit results in a higher probability of successfully completing quantum computation. For this reason, in the case where a quantum gate other than the basic quantum gates is converted into an equivalent circuit, it is desirable to convert the quantum gate into an equivalent circuit using a smaller number of basic quantum gates.

As a technique related to a method of implementing a quantum circuit, for example, a technique for improving the efficiency of an inversion gate implementation in a quantum circuit has been disclosed. Further, there has been proposed a system that analyzes instances and super controlled basis gates and automatically rewrites a source quantum circuit into a deployed quantum circuit based on the analysis. Still further, there has been proposed a system for improving fidelity of a quantum operations on a qubit of interest.

Citation List

Patent Literature

PTL1: Japanese Laid-open Patent Publication No. 2022-530389
PTL2: U.S. Patent Application Publication No. 2020-0134501
PTL3: Japanese Laid-open Patent Publication No. 2014-503890

Summary of Invention

Technical Problem

A $C^k$-NOT gate (k is an integer of 3 or more) is a complex quantum gate that frequently appears in quantum circuits. The superscript of C denotes the number of control qubits. This type of quantum gate is called mixed-polarity multiple-control Toffoli (MPMCT). A $C^k$-NOT gate is a quantum gate that flips the state ($|0\rangle$ or $11\rangle$) of the target qubit when all k control qubits are in the state $11\rangle$). In order to execute a quantum circuit at high speed, it is important to convert each $C^k$-NOT gate into a combination of as few basic quantum gates as possible.

One technique for converting a $C^k$-NOT gate other than the basic quantum gates into an equivalent circuit is a technique that uses ancilla qubits (ancilla bits). In a technique that enables conversion into an equivalent circuit with a smaller number of gates, the larger the number of control qubits in the original $C^k$-NOT gate, the larger the number of ancilla bits to be used.

However, since the number of usable qubits is limited, there are cases where it is not possible to increase the number of ancilla bits. In such cases, it is not possible to apply a technique that enables conversion into an equivalent circuit with a smaller number of gates due to the shortage of ancilla bits. Consequently, the equivalent circuit after conversion may include a larger number of quantum gates.

In one aspect, the present disclosure aims to reduce the number of quantum gates in a quantum circuit.

Solution to Problem

In one aspect, there is provided a quantum circuit design support program that causes a computer to perform the following process.

A computer extracts a first quantum gate from a first quantum circuit that uses k (k is an integer of 3 or more) first qubits as control qubits thereof and one second qubit as a target qubit thereof and that is configured to flip a value of the target qubit in response to all the control qubits being 1. The computer identifies one or more third qubits that each have a predetermined value before a gate operation of the first quantum gate, from among qubits other than the first qubits and the second qubit. The computer determines the number of control qubits for a second quantum gate corresponding to the second qubit and the number of control qubits for each of one or more third quantum gates corresponding respectively to the one or more third qubits so that a sum of numbers of control qubits for the one or more third quantum gates and the number of control qubits for the second quantum gate satisfy a predetermined relationship. The computer generates a second quantum circuit equivalent to the first quantum gate, the second quantum circuit including the one or more third quantum gates and the second quantum gate, the one or more third quantum gates each using first qubits equal in number to the determined number of control qubits as the control qubits thereof and using the corresponding one of the one or more third qubits as a target qubit thereof, the one or more third quantum gates each being configured to flip a value of the target qubit in response to all the control qubits being 1, the second quantum gate using a first qubit not used as the control qubits in the one or more third quantum gates and a third quit as the control qubits thereof and using the second qubit as a target qubit thereof, the second quantum gate being configured to flip a value of the target qubit in response to all the control qubits being 1.

Advantageous Effects of Invention

In one aspect, it is possible to reduce the number of quantum gates in a quantum circuit.

The above and other objects, features and advantages of the present invention will become apparent from the following description taken in conjunction with the accompanying drawings which illustrate, by way of example, preferred embodiments of the invention.

Brief Description of Drawings

[FIG. 1] FIG. 1 illustrates an example of a quantum circuit design support method according to a first embodiment.
[FIG. 2] FIG. 2 illustrates an example of a system configuration according to a second embodiment.
[FIG. 3] FIG. 3 illustrates a configuration example of hardware of a classical computer.
[FIG. 4] FIG. 4 illustrates an example of converting a $C^3$-NOT gate into equivalent circuits.
[FIG. 5] FIG. 5 illustrates an example of converting a $C^4$-NOT gate into equivalent circuits.
[FIG. 6] FIG. 6 illustrates an example of a quantum circuit using a plurality of $C^k$-NOT gates.
[FIG. 7] FIG. 7 illustrates an example of a case where clean qubits are added for conversion of $C^k$-NOT gates.
[FIG. 8] FIG. 8 illustrates an example of state transitions of qubits.
[FIG. 9] FIG. 9 is a block diagram illustrating an example of functions of each apparatus.
[FIG. 10] FIG. 10 is a flowchart illustrating an example procedure for the execution of quantum computation involving the optimization of a quantum circuit.
[FIG. 11] FIG. 11 is a flowchart illustrating an example procedure for a clean bit update process.
[FIG. 12] FIG. 12 illustrates an example of initial information setting in the clean bit update process.
[FIG. 13] FIG. 13 illustrates an example of state transitions of tmpCleanBitList.
[FIG. 14] FIG. 14 illustrates an example of the correspondence relationship between the number of usable ancilla bits and applicable conversion methods.
[FIG. 15] FIG. 15 illustrates an example of an equivalent circuit of a $C^7$-NOT gate according to a first conversion method.
[FIG. 16] FIG. 16 illustrates an example of an equivalent circuit of the $C^7$-NOT gate according to a second conversion method.
[FIG. 17] FIG. 17 illustrates an example of an equivalent circuit of the $C^7$-NOT gate according to a third conversion method.

[FIG. 18] FIG. 18 illustrates an example of an equivalent circuit of the $C^7$-NOT gate according to the basic policy of a fourth conversion method.

[FIG. 19] FIG. 19 illustrates a first example of an equivalent circuit of the $C^7$-NOT gate according to the fourth conversion method in the case where there are only less than (k - 2) clean bits.

[FIG. 20] FIG. 20 illustrates a second example of an equivalent circuit of the $C^7$-NOT gate according to the fourth conversion method in the case where there are only less than (k - 2) clean bits.

[FIG. 21] FIG. 21 illustrates an example of decomposition according to the fourth conversion method in the case of c = 2.

[FIG. 22] FIG. 22 illustrates an example of decomposition according to the fourth conversion method in the case of c = 3.

[FIG. 23] FIG. 23 illustrates an example of functions of a quantum gate conversion unit.

[FIG. 24] FIG. 24 is a flowchart illustrating an example procedure for a quantum gate conversion process.

[FIG. 25] FIG. 25 is a flowchart illustrating an example procedure for a decomposition method determination process.

[FIG. 26] FIG. 26 is a flowchart illustrating an example procedure for an equivalent circuit generation process using the fourth conversion method.

[FIG. 27] FIG. 27 is a flowchart (1/2) illustrating an example procedure for a $C^{k\_i}$-NOT gate conversion process.

[FIG. 28] FIG. 28 is a flowchart (2/2) illustrating the example procedure for the $C^{k\_i}$-NOT gate conversion process.

[FIG. 29] FIG. 29 illustrates an example of converting a $C^k$-NOT gate.

Description of Embodiments

Hereinafter, embodiments will be described with reference to the drawings. A plurality of embodiments may be combined unless they exclude each other.

[First Embodiment]

A first embodiment provides a quantum circuit design support method that appropriately decomposes a $C^k$-NOT gate included in a quantum circuit into a plurality of quantum gates such that the number of quantum gates is reduced in a quantum circuit equivalent to the $C^k$-NOT gate. The quantum circuit equivalent to the $C^k$-NOT gate is, for example, a quantum circuit in which $C^2$-NOT gates (Toffoli gates) are combined.

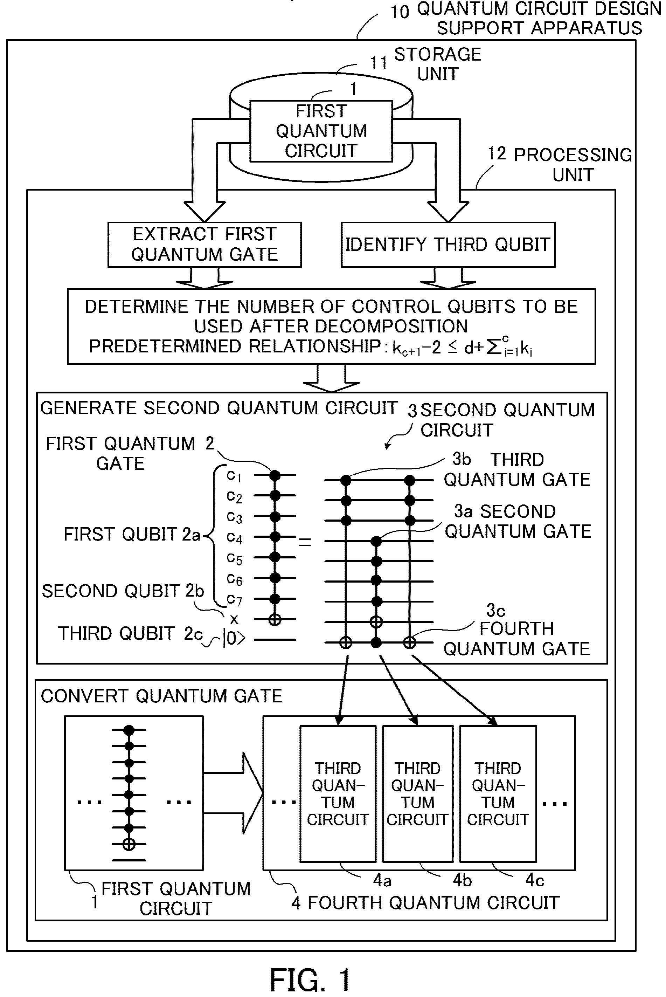

FIG. 1 illustrates an example of the quantum circuit design support method according to the first embodiment. FIG. 1 illustrates a quantum circuit design support apparatus 10 that implements the quantum circuit design support method. The quantum circuit design support apparatus 10 is able to perform the quantum circuit design support method by executing, for example, a quantum circuit design support program.

The quantum circuit design support apparatus 10 includes a storage unit 11 and a processing unit 12. The storage unit 11 is, for example, a memory or a storage device included in the quantum circuit design support apparatus 10. The processing unit 12 is, for example, a processor or an arithmetic circuit included in the quantum circuit design support apparatus 10.

The storage unit 11 stores a first quantum circuit 1 that is to be executed by a quantum computer or a quantum simulator. The first quantum circuit 1 includes a first quantum gate 2 that uses k (k is an integer of 3 or more) first qubits 2a as the control qubits and one second qubit 2b as the target qubit and is configured to flip the value of the target qubit when all the control qubits are 1. The first quantum gate 2 is a $C^k$-NOT gate.

The processing unit 12 decomposes the first quantum gate 2, and after that, converts into an equivalent fourth quantum circuit 4 in which $C^2$-NOT gates are combined. Specifically, for example, the processing unit 12 extracts the first quantum gate 2 from the first quantum circuit 1. Next, the processing unit 12 identifies one or more third qubits 2c that each have a predetermined value before the gate operation of the first quantum gate 2, from among the qubits other than the first qubits 2a and the second qubit 2b. The predetermined value is, for example, $|0\rangle$. For example, the processing unit 12 sets, as a third qubit 2c, a qubit that has an initial state $|0\rangle$ and is not operated by any gate operation from that state. The processing unit 12 also sets, as a third qubit 2c, a qubit whose value is changed to $|0\rangle$ by a gate operation.

The processing unit 12 determines the number of control qubits for a second quantum gate 3a corresponding to the second qubit 2b, and the number of control qubits for each of third quantum gates 3b corresponding respectively to the one or more third qubits 2c. At this time, the processing unit 12 determines the number of control qubits for the second quantum gate 3a and the number of control qubits for each third quantum gate 3b so that the sum of the numbers of control qubits for the one or more third quantum gates 3b and the number of control qubits for the second quantum gate 3a satisfy a predetermined relationship.

For example, the processing unit 12 applies, as the predetermined relationship, a relationship in which a predetermined value based on the number of control qubits for the second quantum gate 3a is less than or equal to the number of qubits that are usable as ancilla bits when the second quantum gate 3a is converted into an equivalent quantum circuit. The predetermined value based on the number of control qubits for the second quantum gate 3a is, for example, a value obtained by subtracting 2 from the number of control qubits. If ancilla bits equal in number to the predetermined value are usable, it is possible to minimize the number of quantum gates in a quantum circuit equivalent to the second quantum gate 3a. The number of qubits that are usable as ancilla bits when the second quantum gate 3a is converted into an equivalent quantum circuit is, for example, the sum of the number of fourth qubits other than the first qubits 2a, the second qubit 2b, and the third qubits 2c and the numbers of control qubits for the one or more third quantum gates 3b.

When the number of control qubits for each of the second quantum gate 3a and the one or more third quantum gates 3b has been determined, the processing unit 12 generates a second quantum circuit 3 including the second quantum gate 3a and the one or more third quantum gates 3b.

Each third quantum gate 3b is a quantum gate that uses first qubits 2a equal in number to the determined number of control qubits as the control qubits and the corresponding third qubit 2c as the target qubit, and is configured to flip the value of the target qubit when all the control qubits are 1. In the case where there are a plurality of third qubits 2c, a plurality of third quantum gates 3b are generated accordingly. At this time, the plurality of third quantum gates 3b use different control qubits.

The second quantum gate 3a uses first qubit(s) 2a not used as the control qubits in the one or more third quantum gates 3b and third qubit(s) 2c as the control qubits and uses the second qubit 2b as the target qubit. The second quantum gate 3a flips the value of the target qubit when all the control qubits are 1.

The processing unit 12 may include one or more fourth quantum gates 3c in the second quantum circuit 3 to restore the original states of the one or more third qubits 2c. For example, the second quantum circuit 3 represents first performing the gate operations of the one or more third quantum gates 3b corresponding respectively to the one or more third qubits 2c. The second quantum circuit 3 then represents performing the gate operation of the second quantum gate 3a. The second quantum circuit 3 then represents performing the gate operations of the one or more fourth quantum gates 3c in reverse order, which perform the same gate operations as the one or more third quantum gates 3b.

As described above, the quantum circuit design support apparatus 10 is able to convert the first quantum gate 2 into the second quantum circuit 3 including the second quantum gate 3a, the one or more third quantum gates 3b, and the one or more fourth quantum gates 3c. Each third quantum gate 3b included in the second quantum circuit 3 is convertible into a third quantum circuit 4a with a smaller number of quantum gates, using a third qubit 2c known to have a predetermined value (for example, 10)) as an ancilla bit. The third quantum circuit 4a is a quantum circuit equivalent to the third quantum gate 3b, in which $C^2$-NOT gates (Toffoli gates) are combined. Like the third quantum gate 3b, each fourth quantum gate 3c is convertible into a third quantum circuit 4c with a smaller number of quantum gates. The third quantum circuit 4c is a quantum circuit equivalent to the fourth quantum gate 3c, in which $C^2$-NOT gates are combined.

In addition, the second quantum gate 3a is convertible into a third quantum circuit 4b in which the number of quantum gates is minimized, using a sufficient number (for example, the number of control qubits minus 2) of qubits that are unknown as to whether they have a predetermined value (for example, $|0\rangle$) as ancilla bits. The third quantum circuit 4b is a quantum circuit equivalent to the second quantum gate 3a, in which $C^2$-NOT gates are combined.

The processing unit 12 decomposes the first quantum gate 2, and after that, converts each decomposed quantum gate into an equivalent quantum circuit such that the number of quantum gates is reduced in a quantum circuit equivalent to the first quantum gate 2. For example, the processing unit 12 converts the second quantum gate 3a, each third quantum gate 3b, and each fourth quantum gate 3c included in the second quantum circuit 3 into the equivalent third quantum circuits 4a, 4b, and 4c, respectively, each configured by combining $C^2$-NOT gates. After that, the processing unit 12 converts the first quantum circuit 1 into the fourth quantum circuit 4 by replacing the first quantum gate 2 in the first quantum circuit 1 with the third quantum circuits 4a, 4b, and 4c.

In this way, the first quantum circuit 1 is converted into the fourth quantum circuit 4 in which the number of $C^2$-NOT gates is minimized. By reducing the number of quantum gates included in the fourth quantum circuit 4, quantum computation using the fourth quantum circuit 4 may be executed efficiently. In addition, the probability of successfully completing the quantum computation using the fourth quantum circuit 4 is also increased.

In this connection, the processing unit 12 is able to determine the number of control qubits for each of the second quantum gate 3a and the one or more third quantum gates 3b by, for example, repeating a process of gradually increasing the number of control qubits for each third quantum gate 3b until the predetermined relationship is satisfied. In this case, the processing unit 12 sets the initial value of the number of control qubits for each third quantum gate 3b to 2, and sets the initial value of the number of control qubits for the second quantum gate 3a to a value obtained by subtracting the number of third qubits 2c from k. Then, the processing unit 12 repeatedly increases the number of control qubits for any third quantum gate 3b (for example, by 1) and decreases the number of control qubits for the second quantum gate 3a by the same amount as the increase until the predetermined relationship is satisfied.

In this way, it is possible to easily determine the number of control qubits for each of the second quantum gate 3a and the third quantum gates 3b so as to satisfy the predetermined relationship.

In this connection, in the case of a plurality of third quantum gates 3b, the processing unit 12 sequentially selects the third quantum gates 3b corresponding respectively to the third qubits 2c in order of execution. The processing unit 12 repeats a process of increasing the number of control qubits for the selected third quantum gate 3b by 1 and decreasing the number of control qubits for the second quantum gate 3a by 1, until the number of control qubits for the selected third quantum gate 3b satisfies a predetermined condition. For example, the predetermined condition is that, with respect to the i-th selected third quantum gate 3b (i is a natural number), the number of control qubits for the third quantum gate 3b is greater than or equal to a value obtained by subtracting i from the number of third qubits 2c and adding 2 to the subtraction result. When the predetermined condition is satisfied, the processing unit 12 selects the next third quantum gate 3b.

Thus, the processing unit 12 is able to effectively use the third qubits 2c that are usable as ancilla bits when converting each third quantum gate 3b into the third quantum circuit 4a equivalent to the third quantum gate 3b. Assume, for example, that a third quantum gate 3b of interest is the first selected quantum gate and the number of third qubits 2c known to have a predetermined value ($|0\rangle$) is 2. In this case, when the third quantum gate 3b is converted into the equivalent third quantum circuit 4a, one of the third qubits 2c is used as the target qubit in the third quantum gate 3b, while the other one is usable as an ancilla bit. In this case, the third quantum gate 3b is able to be decomposed into a plurality of quantum gates in a manner similar to the first quantum gate 2, using the third qubit 2c known to have a value $|0\rangle$ as an ancilla bit. As a result, conversion into a quantum circuit with a smaller number of quantum gates is possible.

[Second Embodiment]

A second embodiment relates to a computer system that converts quantum gates that perform complex gate operations in a quantum circuit into basic quantum gates, and causes a quantum computer to execute quantum computation according to the resulting quantum circuit including only the basic quantum gates. Hereinafter, a qubit that is known to have a value $|0\rangle$ is referred to as a clean qubit or a clean bit. In addition, a qubit that is unknown as to whether it has a value $|0\rangle$ is referred to as a dirty qubit or a dirty bit.

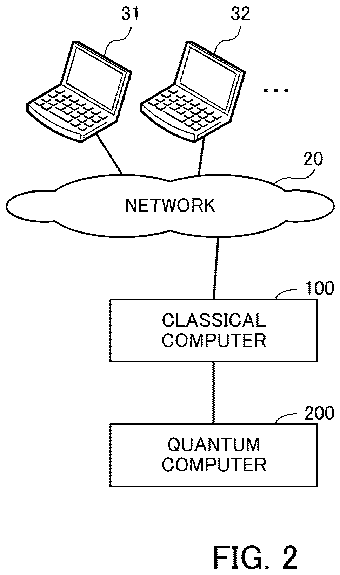

FIG. 2 illustrates an example of a system configuration according to the second embodiment. The system includes a classical computer 100 and a quantum computer 200. Terminals 31, 32, ... are connected to the classical computer 100 via a network 20. The terminals 31, 32, ... are computers used by users who request quantum computation that is to be performed by the quantum computer 200. The classical computer 100 receives quantum circuits from the terminals 31, 32, and .... The quantum circuit includes elements such as gates, whose arrangement represents the order of operations on qubits. A qubit is a bit capable of representing a superposition state of a $|0\rangle$ state and a $|1\rangle$ state.

The classical computer 100 converts the quantum circuits received from the terminals 31, 32, ... into quantum circuits executable by the quantum computer 200. A quantum circuit executable by the quantum computer 200 is, for example, a quantum circuit defined using only basic quantum gates. The classical computer 100 instructs the quantum computer 200 to execute each converted quantum circuit. The classical computer 100 acquires the measurement result of each qubit from the quantum computer 200.

The quantum computer 200 includes a plurality of qubits and a device that manipulates each of the plurality of qubits. The plurality of qubits included in the quantum computer 200 may be, for example, superconducting qubits or trapped-ion qubits. Alternatively, the plurality of qubits may be diamond spin qubits. In the case of superconducting qubits, the quantum computer 200 may include a refrigerator for cooling the qubits.

The quantum computer 200 irradiates qubits with microwaves, for example, in response to an instruction from the classical computer 100. The device that manipulates the plurality of qubits measures the state of each of the plurality of qubits and transmits the measurement result to the classical computer 100.

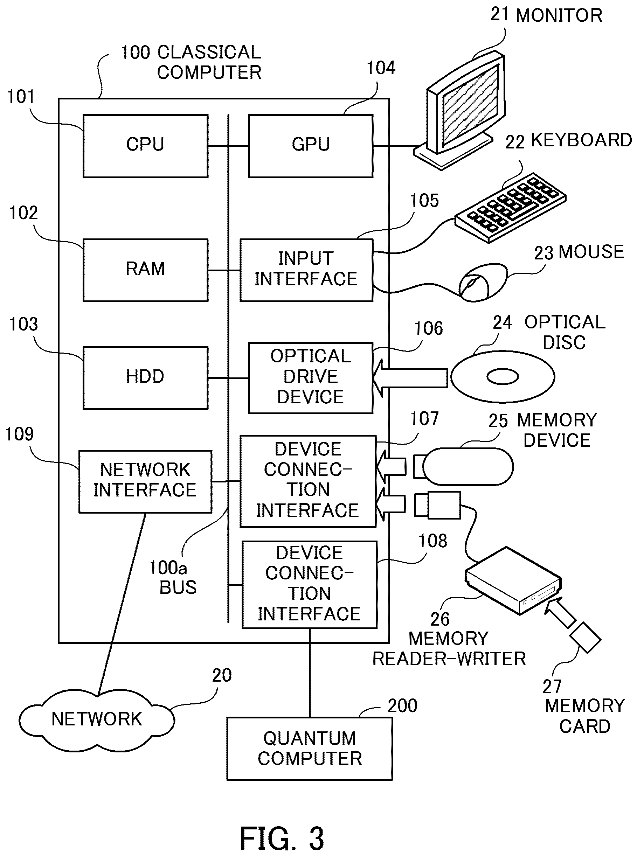

FIG. 3 illustrates a configuration example of hardware of a classical computer. The entire classical computer 100 is controlled by a central processing unit (CPU) 101. The CPU 101 is a processor that executes program instructions. The CPU 101 may include a plurality of processor cores. The CPU 101 may include a plurality of processors or may also be a micro processing unit (MPU), a digital signal processor (DSP), or the like. At least a part of the functions implemented by the CPU 101 executing programs may be implemented by an electronic circuit such as an application specific integrated circuit (ASIC) or a programmable logic device (PLD). A random access memory (RAM) 102 and a plurality of peripheral devices are connected to the CPU 101 via a bus 100a.

The RAM 102 is a main storage device of the classical computer 100. The RAM 102 temporarily stores at least part of operating system (OS) programs and application programs to be executed by the CPU 101. The RAM 102 stores various data used by the CPU 101 during processing. The classical computer 100 may include a type of memory other than RAM, or may include a plurality of memories.

The peripheral devices connected to the bus 100a include a hard disk drive (HDD) 103, a graphics processing unit (GPU) 104, an input interface 105, an optical drive device 106, device connection interfaces 107 and 108, and a network interface 109.

The HDD 103 is an auxiliary storage device of the classical computer 100. The HDD 103 magnetically writes and reads data to and from a built-in magnetic disk. The HDD 103 stores OS programs, application programs, and various data. The classical computer 100 may include another type of auxiliary storage device such as a flash memory or a solid state drive (SSD), or may include a plurality of auxiliary storage devices.

A monitor 21 is connected to the GPU 104. The GPU 104 displays images on the screen of the monitor 21 in accordance with instructions from the CPU 101. Examples of the monitor 21 include a display device using organic electro luminescence (EL), a liquid crystal display device, and others.

A keyboard 22 and a mouse 23 are connected to the input interface 105. The input interface 105 transmits signals sent from the keyboard 22 and the mouse 23 to the CPU 101. The mouse 23 is an example of a pointing device, and other pointing devices may be used. Examples of other pointing devices include a touch panel, a tablet, a touch pad, and a track ball.

The optical drive device 106 uses laser light or the like to read data recorded on an optical disc 24. The optical disc 24 is a portable storage medium on which data is recorded so as to be readable by reflection of light. The optical disc 24 may be a digital versatile disc (DVD), a DVD-RAM, a compact disc read only memory (CD-ROM), a CD-recordable (CD-R), CD-rewritable (CD-RW), or the like.

The device connection interface 107 is a communication interface for connecting peripheral devices to the classical computer 100. For example, a memory device 25 and a memory reader-writer 26 may be connected to the device connection interface 107. The memory device 25 is a storage medium having a function of communicating with the device connection interface 107. The memory reader-writer 26 is a device that writes data to a memory card 27 or reads data from the memory card 27. The memory card 27 is a card-type storage medium.

The device connection interface 108 is a communication interface for connecting the quantum computer 200 to the classical computer 100. The classical computer 100 transmits an instruction for controlling qubits to the quantum computer 200 via the device connection interface 108.

The network interface 109 is connected to the network 20. The network interface 109 transmits and receives data to and from other computers or communication devices via the network 20.

The classical computer 100 is able to implement the processing functions of the second embodiment with the hardware configuration as described above. The quantum circuit design support apparatus 10 described in the first embodiment is also implemented with hardware similar to that of the classical computer 100 illustrated in FIG. 3. The CPU 101 is an example of the processing unit 12 described in the first embodiment.

The classical computer 100 implements the processing functions of the second embodiment by executing a program stored on a computer-readable storage medium, for example. The program describing the processing contents to be executed by the classical computer 100 may be stored on various storage media. For example, a program to be executed by the classical computer 100 may be stored on the HDD 103. The CPU 101 loads at least part of the program from the HDD 103 into the RAM 102 and executes the program. The program to be executed by the classical computer 100 may be stored on a portable storage medium such as the optical disc 24, the memory device 25, or the memory card 27. The program stored on the portable storage medium becomes executable after being installed in the HDD 103 under the control of the CPU 101, for example. Alternatively, the CPU 101 may read the program directly from the portable storage medium and perform the program.

In the system as described above, the classical computer 100 acquires, from the terminals 31, 32, and ..., quantum circuits each representing a procedure of gate operations on qubits for quantum computation. Each quantum circuit obtained from the terminals 31, 32, ... includes quantum gates that perform complex operations other than the basic quantum gates. However, the gate operations executable by the quantum computer 200 are limited to the gate operations of the basic quantum gates. Therefore, the classical computer 100 converts quantum gates other than the basic quantum gates included in each quantum circuit acquired from the terminals 31, 32, and ... into equivalent circuits using the basic quantum gates executable by the quantum computer 200. Then, the classical computer 100 instructs the quantum computer 200 to perform quantum computation using the converted quantum circuit.

Which quantum gates are the basic quantum gates varies depending on a system. In the system according to the second embodiment, the Hadamard gate, the NOT gate, and the rotation gate among the one-qubit gates are included in the basic quantum gates. Among the two qubit gates, the C-NOT gate and the controlled rotation gate are included in the basic quantum gates. Among the three-qubit gates, the $C^2$-NOT gate is included in the basic quantum gates.

A $C^k$-NOT gate (k is an integer of 3 or more) is a frequently used quantum gate among quantum gates that perform complex gate operations other than the basic quantum gates. The $C^k$-NOT gate is a quantum gate that flips "0/1" of the target qubit when all k control qubits are in the state 11).

The gate operation of the $C^k$-NOT gate is replaceable with an equivalent quantum circuit constructed with a minimum number of $C^2$-NOT gates, depending on the number of clean ancilla bits and the number of dirty ancilla bits.

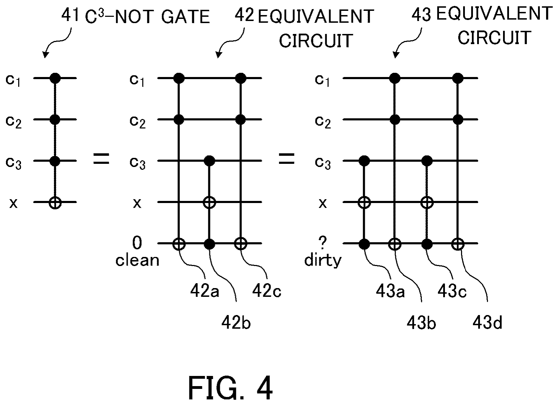

FIG. 4 illustrates an example of converting a $C^3$-NOT gate into equivalent circuits. A $C^3$-NOT gate 41 uses three qubits "$c_1$" to "$c_3$" as the control qubits and uses a qubit "x" as the target qubit. In the case where a clean ancilla bit is usable, the $C^3$-NOT gate 41 is convertible into an equivalent circuit 42. The equivalent circuit 42 includes three $C^2$-NOT gates 42a to 42c. In the case where no clean ancilla bit is usable and a dirty ancilla bit is usable, the $C^3$-NOT gate 41 is convertible into an equivalent circuit 43. The equivalent circuit 43 includes four $C^2$-NOT gates 43a to 43d.

Thus, if a clean ancilla bit is usable, the $C^3$-NOT gate 41 is convertible into the three $C^2$-NOT gates 42a to 42c. On the other hand, if only a dirty ancilla bit is usable, the $C^3$-NOT gate 41 is converted into the four $C^2$-NOT gates 43a to 43d. That is, the use of a clean ancilla bit allows for a reduction in the number of quantum gates in the converted quantum circuit.

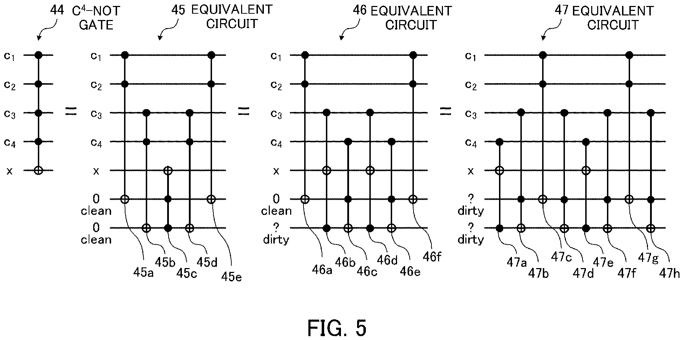

FIG. 5 illustrates an example of converting a $C^4$-NOT gate into equivalent circuits. A $C^4$-NOT gate 44 uses four qubits "$c_1$" to "$c_4$" as the control qubits and uses a qubit "x" as the target qubit. In the case where two clean ancilla bits are usable, the $C^4$-NOT gate 44 is convertible into an equivalent circuit 45. The equivalent circuit 45 includes five $C^2$-NOT gates 45a to 45e. In the case where one clean ancilla bit and one dirty ancilla bit are usable, the $C^4$-NOT gate 44 is convertible into an equivalent circuit 46. The equivalent circuit 46 includes six $C^2$-NOT gates 46a to 46f. Further, in the case where no clean ancilla bit is usable but two dirty ancilla bits are usable, the $C^4$-NOT gate 44 is convertible into an equivalent circuit 47. The equivalent circuit 47 includes eight $C^2$-NOT gates 47a to 47h.

Thus, if two clean ancilla bits are usable, the $C^4$-NOT gate 44 is convertible into the five $C^2$-NOT gates 45a to 45e. If only one clean ancilla bit is usable, the $C^4$-NOT gate 44 is converted into the six $C^2$-NOT gates 46a to 46f. If only dirty ancilla bits are usable, the $C^4$-NOT gate 44 is converted into the eight $C^2$-NOT gates 47a to 47h. That is, the use of more clean ancilla bits allows for a reduction in the number of quantum gates in the converted quantum circuit.

As illustrated in FIGS. 4 and 5, if clean qubits are known, the $C^k$-NOT gate is convertible into an equivalent circuit with a small number of gates, using the clean qubits as ancilla bits. To this end, it is important to manage which qubits are in a clean state.

Consider the case where a quantum circuit includes a plurality of quantum gates. If it is not managed which qubits are clean, the states of all the qubits are treated only as dirty. As a result, a $C^3$-NOT gate is converted into the equivalent circuit 43 (see FIG. 4), and a $C^4$-NOT gate is converted into the equivalent circuit 47 (see FIG. 5).

If a quantum circuit includes only a small number of quantum gates other than the basic quantum gates, no serious problem occurs. However, a quantum circuit generated in a circuit description language often includes a large number of quantum gates other than the basic quantum gates.

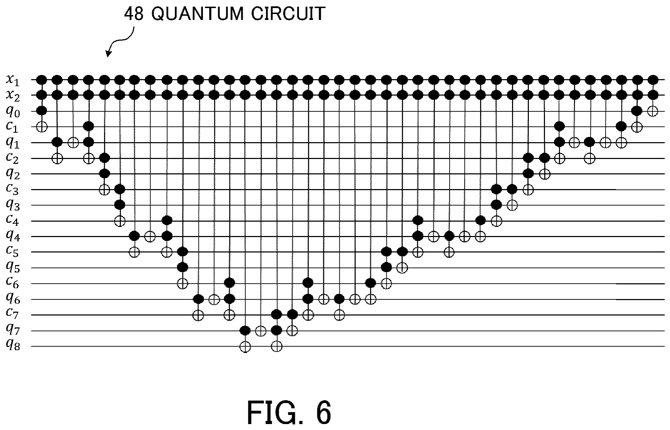

FIG. 6 illustrates an example of a quantum circuit using a plurality of $C^k$-NOT gates. A quantum circuit 48 represents a quantum computation of adding "211" to the numerical value (binary notation) represented by a qubit array "q $= q_8, ..., q_0$" when a qubit "$x_1$" and a qubit "$x_2$" satisfy "$x_1 = x_2 = 1$". The quantum circuit 48 uses many $C^k$-NOT gates. At this time, if it is not known which qubits are clean, all the $C^k$-NOT gates are converted into equivalent circuits each having a large number of gates. As a result, the number of quantum gates significantly increases in the converted quantum circuit as a whole.

Specifically, the quantum circuit 48 includes 11 $C^2$-NOT gates, 16 $C^3$-NOT gates, and 13 $C^4$-NOT gates. The 16 $C^3$-NOT gates are converted into 64 $C^2$-NOT gates according to the equivalent circuit 43. The 13 $C^4$-NOT gates are converted into 104 $C^2$-NOT gates according to the equivalent circuit 47. As a result, a quantum circuit that performs the gate operations of 179 $C^2$-NOT gates on 18 qubits is generated.

In this connection, even in the case where the number of clean ancilla bits is insufficient, a $C^k$-NOT is convertible into the equivalent circuit 45 including the minimum number of $C^2$-NOT gates if clean qubits are added to make up for the shortage.

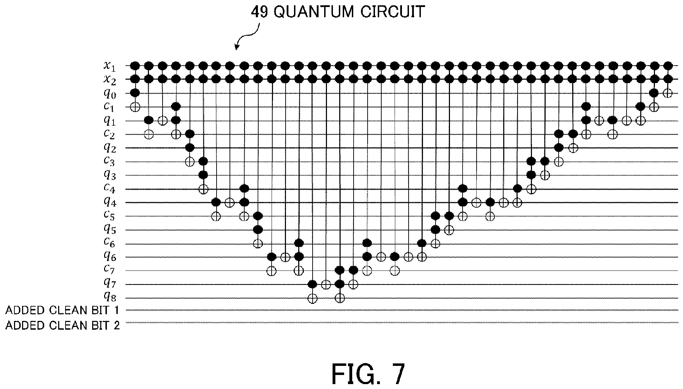

FIG. 7 illustrates an example of a case where clean qubits are added for conversion of $C^k$-NOT gates. In a quantum circuit 49, two clean qubits are added. Using the added qubits as ancilla bits, each $C^k$-NOT is convertible into an equivalent circuit including a minimum number of $C^2$-NOT gates. In this case, the addition of the clean qubits increases the number of qubits used to execute the quantum circuit. The number of usable qubits is limited in a quantum computer. Therefore, if the number of qubits to be used increases, there is a possibility that the quantum computer is not able to execute the converted quantum circuit.

Specifically, the 16 $C^3$-NOT gates included in the quantum circuit 49 are converted into 48 $C^2$-NOT gates according to the equivalent circuit 42. The 13 $C^4$-NOT gates are converted into 65 $C^2$-NOT gates according to the equivalent circuit 45. As a result, a quantum circuit that performs the gate operations of 124 $C^2$-NOT gates on 20 qubits is generated. In this way, the addition of clean qubits as ancilla bits reduces the number of quantum gates after conversion, but increases the number of qubits. As a result, an error of failing to execute the quantum circuit due to a shortage of usable qubits may occur.

To deal with this, a clean bit management function is introduced into the classical computer 100 so that the classical computer 100 manages, for each gate operation and for each qubit used in a quantum circuit, whether the state of the qubit after the gate operation is clean or dirty.

Generally, the initial state of each qubit is clean. Even in the case where a qubit is changed to a dirty state by a subsequent gate operation, the qubit is returned to the clean state if a gate operation that changes the state to $|0\rangle$ is performed on the qubit.

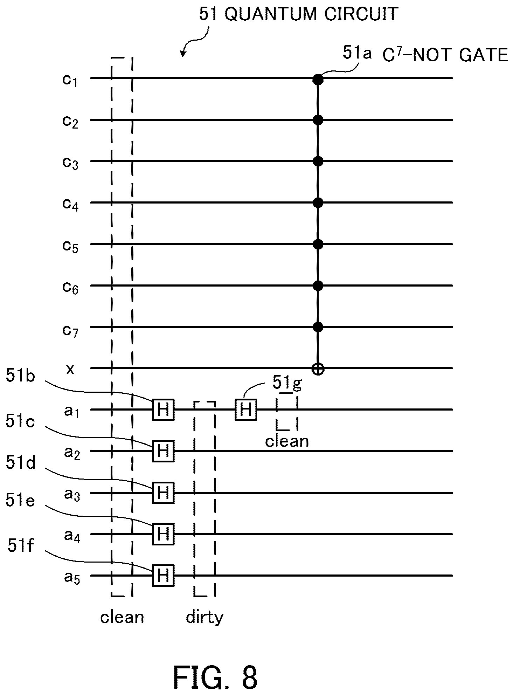

FIG. 8 illustrates an example of state transitions of qubits. In the case where the initial states of qubits are $|0\rangle$), all the qubits are clean at the stage at which a quantum circuit is input to the quantum computer 200 (before gate operations). When the operation of a quantum gate in the quantum circuit input to the quantum computer 200 is executed, a qubit serving as the target qubit in the quantum gate may be changed from clean to dirty. Even if the qubit is changed to dirty, the qubit becomes clean when the state of the qubit is returned to $|0\rangle$ by a certain quantum gate.

For example, a quantum circuit 51 includes a $C^7$-NOT gate 51a and six Hadamard gates 51b to 51g. The $C^7$-NOT gate 51a uses seven qubits "$c_1$" to "$c_7$" as the control qubits and uses a qubit "x" as the target qubit. When the states of all the control qubits are $|1\rangle$, the $C^7$-NOT gate 51a flips the state of the target qubit (flips the state from $|0\rangle$ to $|1\rangle$ or from $|1\rangle$ to 10)).

The Hadamard gates 51b to 51f are placed on five qubits "$a_1$" to "$a_5$", respectively. The Hadamard gate 51g is further placed on the qubit "$a_1$".

Before the gate operations in the quantum circuit 51 are applied, the states of all the qubits are clean. After the gate operations of the Hadamard gates 51b to 51f are performed on the five qubits "$a_1$" to "$a_5$", the states of the five qubits "$a_1$" to "$a_5$" change from clean to dirty. When the gate operation of the second Hadamard gate 51g is performed on the qubit "$a_1$", the state of the qubit "$a_1$" changes from dirty to clean.

In the case where the last $C^7$-NOT gate 51a is converted into an equivalent circuit in the example of the quantum circuit 51, the qubit "$a_1$" is usable as a clean ancilla bit, and the qubits "$a_2$" to "$a_5$" are usable as dirty ancilla bits.

As described above, each qubit is clean in the initial state. A qubit becomes dirty when some gate operation is performed on it. Even if the qubit becomes dirty, the state of the qubit becomes clean when the same gate operation as before is performed again.

When a SWAP gate is executed, the state of a dirty qubit may change to clean. The SWAP gate is a quantum gate that performs an operation of swapping the states of two qubits. For example, there is a case where the state of one qubit to be operated by the SWAP gate is clean and the state of the other qubit is dirty. In this case, by executing the SWAP gate, the qubit in the clean state is changed to dirty, and the qubit in the dirty state is changed to clean.

Therefore, with the clean bit management function, the classical computer 100 changes a qubit from clean to dirty when the operation of a quantum gate that uses the clean qubit as the target qubit is performed. In addition, when the operation of the SWAP gate is performed, the classical computer 100 swaps the states of both qubits to be operated. Further, when an operation of changing a qubit that is dirty to $|0\rangle$ is performed, the classical computer 100 changes the qubit from dirty to clean.

Note that there are gate operations, other than the Hadamard gate, in which, by performing the gate operation of a predetermined quantum gate twice on a clean bit, the qubit returns to the clean bit. For example, in the case where the gate operation of a NOT gate is performed twice on a clean bit, the qubit becomes a dirty bit by the first execution of the NOT gate operation, but returns to the clean bit by the second execution of the NOT gate operation.

With the above clean bit management function, the classical computer 100 is able to convert every $C^k$-NOT gate appearing in a quantum circuit into an optimal equivalent circuit that is determined based on the number of clean ancilla bits and the number of dirty ancilla bits, without increasing the number of qubits. This results in a reduction in the computation time of the quantum computer 200. This also holds true for the case where a quantum circuit simulator is used instead of the quantum computer 200.

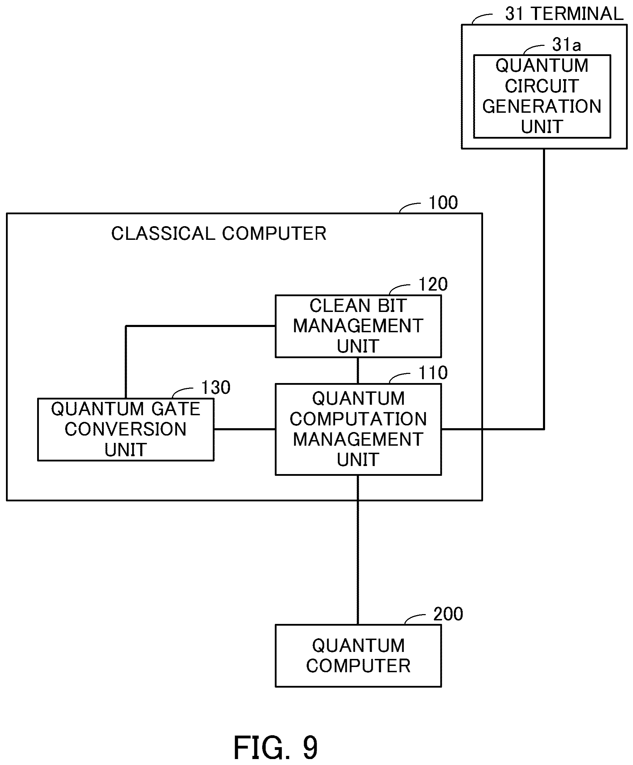

FIG. 9 is a block diagram illustrating an example of functions of each apparatus. The terminal 31 includes a quantum circuit generation unit 31a. The quantum circuit generation unit 31a generates a quantum circuit in a circuit description language according to inputs from a user. Quantum gates other than the basic quantum gates are also used in the quantum circuit generated by the quantum circuit generation unit 31a. The quantum circuit generation unit 31a transmits the generated quantum circuit to the classical computer 100.

The classical computer 100 includes a quantum computation management unit 110, a clean bit management unit 120, and a quantum gate conversion unit 130.

The quantum computation management unit 110 manages the execution of quantum computation based on the quantum circuit received from the terminal 31. For example, in the case where the quantum circuit received from the terminal 31 includes quantum gates other than the basic quantum gates, the quantum computation management unit 110 instructs the quantum gate conversion unit 130 to convert these quantum gates into equivalent circuits. The quantum computation management unit 110 instructs the management of the state (clean/dirty) of each qubit after the operation of each quantum gate in the quantum circuit. When a quantum circuit defined using only the basic quantum gates is generated, the quantum computation management unit 110 instructs the quantum computer 200 to perform quantum computation based on the quantum circuit. Then, the quantum computation management unit 110 acquires the computation result from the quantum computer 200 and outputs the computation result to the terminal 31.

The clean bit management unit 120 manages the state of each qubit that is operated in the quantum circuit. For example, the clean bit management unit 120 interprets the operations of the quantum gates in the quantum circuit in order starting from the first quantum gate, and determines whether the state of the operated qubit is clean or dirty after the gate operation.

The quantum gate conversion unit 130 converts the quantum gates other than the basic quantum gates included in the quantum circuit into equivalent circuits each using only the basic quantum gates. At this time, the quantum gate conversion unit 130 acquires, from the clean bit management unit 120, the state of each qubit immediately before the execution of the quantum gate to be converted. Then, the quantum gate conversion unit 130 identifies clean qubits and dirty qubits that are usable as ancilla bits, and converts the quantum gate to be converted, into a minimum equivalent circuit using these qubits effectively.

The function of each element illustrated in FIG. 9 may be implemented by causing a computer to execute a program module corresponding to the element, for example.

Next, a procedure for executing quantum computation involving the optimization of a quantum circuit will be described in detail.

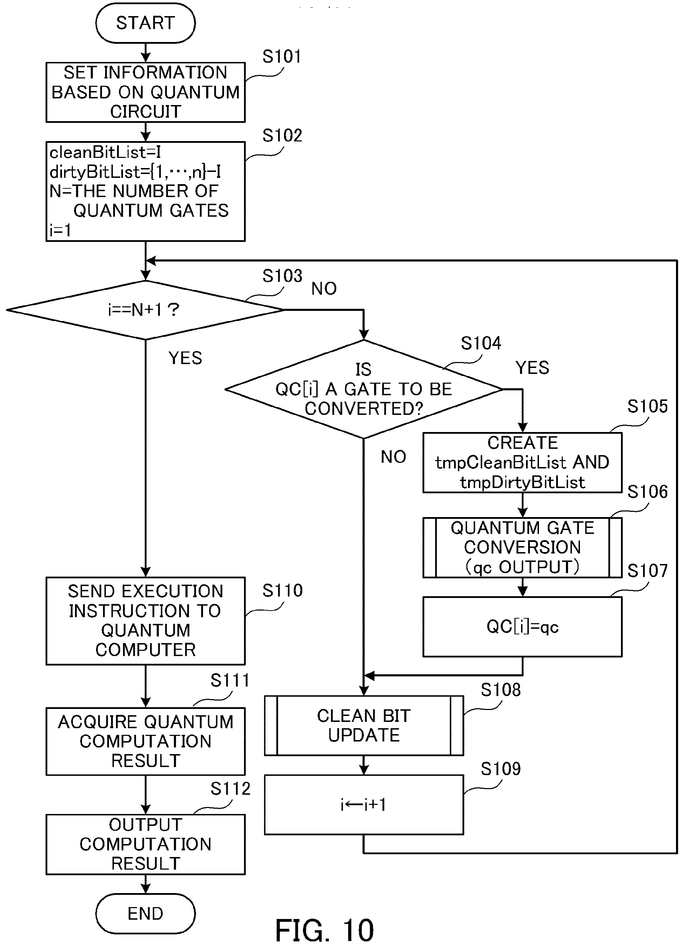

FIG. 10 is a flowchart illustrating an example procedure for the execution of quantum computation involving the optimization of a quantum circuit. Hereinafter, the process of FIG. 10 will be described in order of step numbers.

[Step S101] The quantum computation management unit 110 acquires a quantum circuit to be computed from one of the terminals 31, 32, .... The quantum computation management unit 110 instructs the clean bit management unit 120 to set information for clean bit management based on the acquired quantum circuit. Then, the clean bit management unit 120 analyzes the designated quantum circuit and sets circuit information used for the clean bit management. The circuit information to be set includes, for example, the number of qubits n, a quantum circuit "QC", an initial state I, and cleaning information CI.

The number of qubits n is the number of qubits appearing in the quantum circuit. The number of qubits n is the minimum number of qubits for executing the received quantum circuit.

The quantum circuit "QC" is represented as a sequence of information including {gate index, quantum gate configuration} in order. The quantum gate configuration includes the type of a quantum gate, the indices of qubits to be operated, and others. For example, "QC" is information like [{1, Hadamard gate for first qubit}, {2, $C^{10}$-NOT gate using first to tenth qubits as control qubits and eleventh qubit as target qubit}, ...].

The initial state I is a set of the indices of clean qubits. For example, in the case where the first, second, and tenth qubits are clean, the initial state I is {1, 2, 10}.

The cleaning information CI is a set of the identification numbers of quantum gates that each change the state of the target qubit to clean. For example, in the case where the execution of each of the fifth quantum gate and the ninth quantum gate changes the state of the target qubit to clean, the cleaning information CI is {5, 9}. In the example of the quantum circuit 51 illustrated in FIG. 8, the identification number of the Hadamard gate 51g is set in the cleaning information CI.

[Step S102] The quantum computation management unit 110 and the clean bit management unit 120 generate an initial state for information used for the optimization of the quantum circuit. For example, the clean bit management unit 120 generates an initial state for information used for managing the state changes of qubits each time a gate operation is performed. The information used for managing the state changes of the qubits includes a list "cleanBitList" of clean qubits, a list "dirtyBitList" of dirty qubits, and the number of quantum gates "N" included in "QC".

The initial value of "cleanBitList" is the initial state I (cleanBitList = I). The initial value of "dirtyBitList" is obtained by excluding the qubits included in the initial state I from the list of all qubits (dirtyBitList = {1, ..., n} - I). "N" is set to the maximum value among the identification numbers of the quantum gates included in "QC".

The quantum computation management unit 110 sets an initial value for a variable "i" indicating in what order the currently processed quantum gate appears. For example, the initial value for "i" is "1" (i = 1).

[Step S103] The quantum computation management unit 110 determines whether the conversion of quantum gates other than the basic quantum gates into equivalent circuits is completed, based on whether the value of "i" is "N + 1". For example, if "i == N + 1", the quantum computation management unit 110 advances the process to step S110. If "i == N + 1" is not satisfied, the quantum computation management unit 110 advances the process to step S104.

[Step S104] The quantum gate conversion unit 130 determines whether the i-th quantum gate "QC[i]" in "QC" is to be converted into an equivalent circuit. A quantum gate to be converted into an equivalent circuit is a quantum gate other than the basic quantum gates. If the i-th quantum gate is to be converted into an equivalent circuit, the quantum gate conversion unit 130 advances the process to step S105. If the i-th quantum gate is not to be converted into an equivalent circuit, the quantum gate conversion unit 130 advances the process to step S108.

[Step S105] The quantum gate conversion unit 130 creates a temporary list "tmpCleanBitList" of clean qubits and a temporary list "tmpDirtyBitList" of dirty qubits. For example, the quantum gate conversion unit 130 sets "tmpCleanBitList" by removing the identification numbers of the control qubits and target qubit in QC[i] from "cleanBitList". The quantum gate conversion unit 130 sets "tmpDirtyBitList" by removing the identification numbers of the control qubits and target qubit in QC[i] from "dirtyBitList".

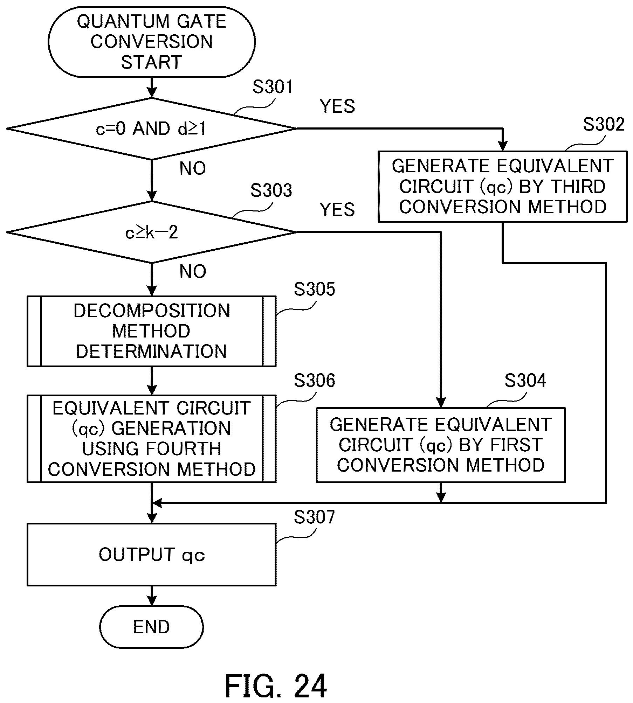

[Step S106] The quantum gate conversion unit 130 performs a process (quantum gate conversion) of converting the quantum gate QC[i] into an equivalent circuit based on QC[i], "tmpCleanBitList", and "tmpDirtyBitList". The equivalent circuit obtained as a result of the quantum gate conversion is denoted by "qc". The details of the quantum gate conversion process will be described later (see FIG. 24).

[Step S107] The quantum gate conversion unit 130 replaces QC[i] with the equivalent circuit "qc" generated in the quantum gate conversion process (QC[i] = qc).

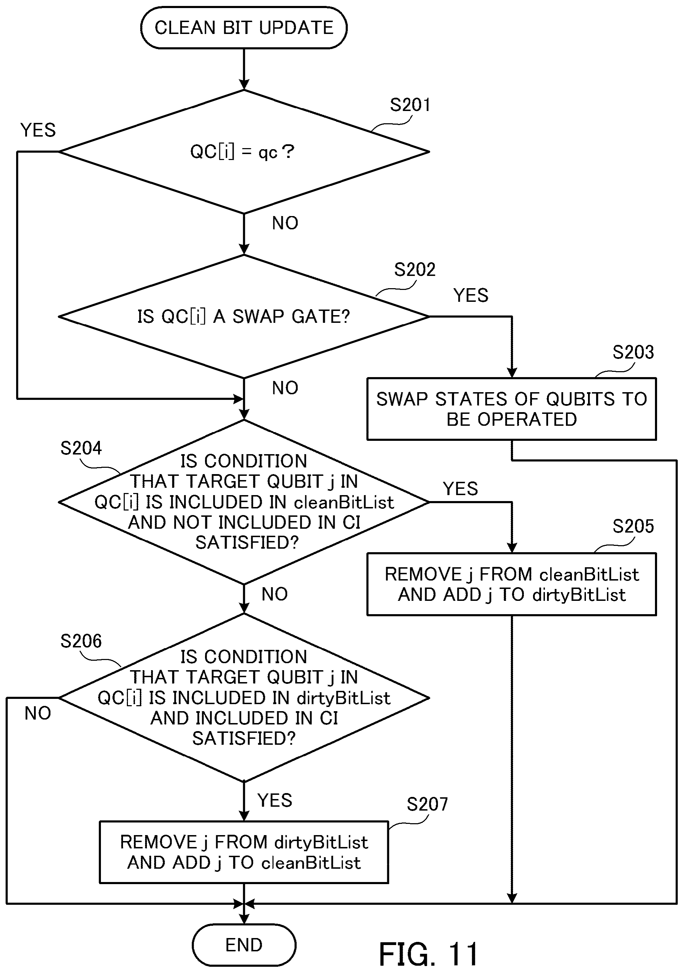

[Step S108] The clean bit management unit 120 performs a clean bit update process in response to the execution of the gate operation of QC[i]. The details of the clean bit update process will be described later (see FIG. 11).

[Step S109] The quantum computation management unit 110 adds 1 to the variable "i" ($i \leftarrow i + 1$), and advances the process to step S103.

[Step S110] The quantum computation management unit 110 instructs the quantum computer 200 to execute quantum computation based on the quantum circuit.

[Step S111] The quantum computation management unit 110 acquires a computation result from the quantum computer 200.

[Step S112] The quantum computation management unit 110 outputs the result of the quantum computation based on the quantum circuit.

In this way, it is determined whether each quantum gate is to be converted into an equivalent circuit, and quantum gates, if determined to be converted, are converted into equivalent circuits. Each time the process is completed for one quantum gate, the state of each qubit is updated to the one obtained by the gate operation of the quantum gate. As a result, when a quantum gate is to be converted into an equivalent circuit, the quantum gate conversion unit 130 is able to correctly identify clean qubits at the time of the execution of the gate operation of the quantum gate to be converted, and to perform the conversion into an equivalent circuit with a smaller number of quantum gates depending on the number of clean qubits.

Next, a procedure for the clean bit update process will be described in detail.

FIG. 11 is a flowchart illustrating an example procedure for the clean bit update process. Hereinafter, the process of FIG. 11 will be described in order of step numbers. In the process of FIG. 11, even after the quantum gate QC[i] is converted into an equivalent circuit "qc", the quantum gate QC[i] indicates the i-th quantum gate before the conversion.

[Step S201] The clean bit management unit 120 determines whether the quantum gate QC[i] to be processed has been converted into an equivalent circuit "qc". If the conversion has been performed, the clean bit management unit 120 advances the process to step S204. On the other hand, if the conversion has not been performed, the clean bit management unit 120 advances the process to step S202.

[Step S202] The clean bit management unit 120 determines whether the quantum gate QC[i] is a SWAP gate. If it is a SWAP gate, the clean bit management unit 120 advances the process to step S203. On the other hand, if it is not a SWAP gate, the clean bit management unit 120 advances the process to step S204.

[Step S203] The clean bit management unit 120 swaps the states of the qubits to be operated by the quantum gate (SWAP gate) to be processed. For example, in the case where one of the identification numbers "j, k" of the qubits to be operated is included in "cleanBitList" and the other is included in "dirtyBitList", the clean bit management unit 120 swaps the lists to which the qubits belong.

Specifically, the clean bit management unit 120 removes the identification number ("j" or "k") of the qubit to be operated, included in "cleanBitList", from "cleanBitList" and adds the identification number to "dirtyBitList". In addition, the clean bit management unit 120 removes the identification number ("j" or "k") of the qubit to be operated, included in "dirtyBitList", from "dirtyBitList" and adds the identification number to "cleanBitList".

When the state swapping is complete, the clean bit management unit 120 ends the clean bit update process.

[Step S204] The clean bit management unit 120 determines whether a condition that the identification number [j] of the target qubit in the quantum gate QC[i] is included in "cleanBitList" and is not included in the cleaning information CI is satisfied. If the condition is satisfied, the clean bit management unit 120 advances the process to step S205. If the condition is not satisfied, the clean bit management unit 120 advances the process to step S206.

[Step S205] The clean bit management unit 120 removes the identification number [j] of the target qubit in the quantum gate QC[i] from "cleanBitList" and adds the identification number [j] to "dirtyBitList". Thereafter, the clean bit management unit 120 ends the clean bit update process.

[Step S206] The clean bit management unit 120 determines whether a condition that the identification number [j] of the target qubit in the quantum gate QC[i] is included in "dirtyBitList" and is also included in the cleaning information CI is satisfied. if the condition is satisfied, the clean bit management unit 120 advances the process to step S207. If the condition is not satisfied, the clean bit management unit 120 ends the clean bit update process.

[Step S207] The clean bit management unit 120 removes the identification number [j] of the target qubit in the quantum gate QC[i] from "dirtyBitList" and adds the identification number [j] to "cleanBitList". Thereafter, the clean bit management unit 120 ends the clean bit update process.

In this way, the state (clean or dirty) of the qubit operated by each quantum gate is appropriately managed.

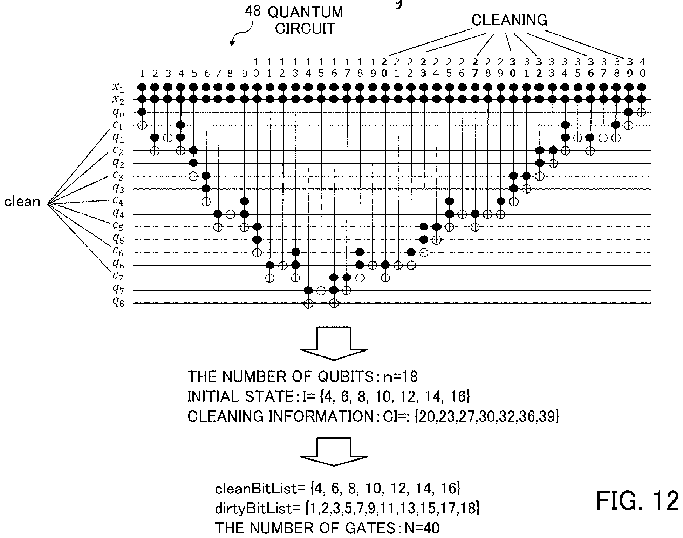

FIG. 12 illustrates an example of initial information setting in the clean bit update process. The example of FIG. 12 assumes that quantum gates other than the basic quantum gates in the quantum circuit 48 illustrated in FIG. 6 are converted into equivalent circuits.

The quantum circuit 48 is a circuit that adds "211" to the qubit array "$q_8, ..., q_0$" (binary notation) when both the qubits "$x_1$" and "$x_2$" are in the state 11). In the quantum circuit 48, seven clean qubits "$c_1, ..., c_7$" are usable as ancilla bits.

The number of qubits used in the quantum circuit 48 is 18, and n is therefore set to 18. Among these qubits, the identification numbers of the clean qubits "$c_1, ..., c_7$" are "4, 6, 8, 10, 12, 14, 16", respectively. Therefore, the initial state I is set to "I = {4, 6, 8, 10, 12, 14, 16}".

Among the quantum gates included in the quantum circuit 48, seven quantum gates ordered as 20, 23, 27, 30, 32, 36, and 39 each perform a gate operation that changes the state of the target qubit to 10). Therefore, the cleaning information CI is set to "CI = {20, 23, 27, 30, 32, 36, 39}".

Before the optimization of the quantum circuit is performed, "cleanBitList = {4, 6, 8, 10, 12, 14, 16}" having the same content as the initial state I is generated. In addition, "dirtyBitList = {1, 2, 3, 5, 7, 9, 11, 13, 15, 17, 18}" indicating dirty qubits is generated.

Since the quantum circuit 48 includes 40 quantum gates, the number of gates is set to "N = 40".

"cleanBitList" and "dirtyBitList" are updated each time it is determined whether the conversion of one quantum gate into an equivalent circuit is needed and the conversion to an equivalent circuit is performed when the conversion is determined to be needed. When a quantum gate is converted into an equivalent circuit, "tmpCleanBitList" is generated based on "cleanBitList" of that time. "tmpCleanBitList" indicates qubits that are usable as clean ancilla bits in the equivalent circuit of the quantum gate. Further, "tmpDirtyBitList" is generated based on "dirtyBitList". "tmpDirtyBitList" indicates qubits that are usable as dirty ancilla bits in the equivalent circuit of the quantum gate.

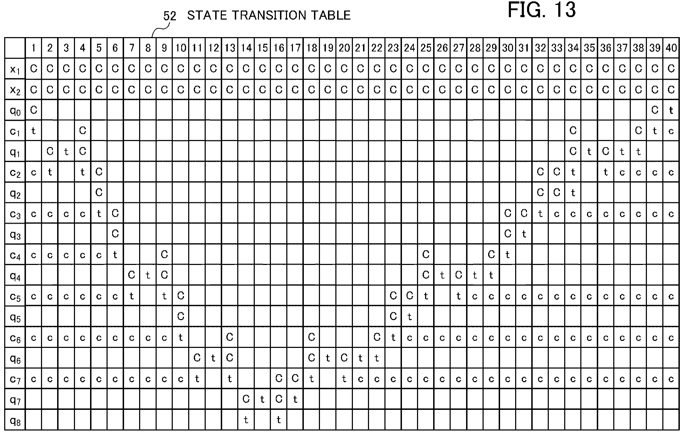

FIG. 13 illustrates an example of state transitions of tmpCleanBitList. In a state transition table 52 for tmpCleanBitList, each column has a label indicating the index of a quantum gate. In the state transition table 52 for "tmpCleanBitList", each row has a label indicating a qubit.

In the state transition table 52, each cell, defined by a qubit and a quantum gate, indicates the state (clean or dirty) of the qubit before the operation of the quantum gate. "C" indicates that the corresponding qubit is a control qubit in the corresponding quantum gate. "t" indicates that the corresponding qubit is the target qubit in the corresponding quantum gate. "c" indicates that the corresponding qubit is a clean qubit, and the identification number of the qubit is included in "tmpCleanBitList". A blank cell means that the corresponding qubit is a dirty qubit, and the identification number of the qubit is included in "tmpDirtyBitList".

In the example illustrated in FIGS. 12 and 13, there are enough dirty bits that are usable as ancilla bits. Therefore, an equivalent circuit into which a $C^k$-NOT gate is converted is determined based on the number of usable clean bits.

Among the quantum gates of the quantum circuit 48, $C^2$-NOT gates do not need conversion. A total of 11 quantum gates "3, 8, 12, 15, 19, 21, 26, 28, 35, 37, 40" do not need the conversion.

Among the $C^3$-NOT gates, those that are able to use at least one clean bit as an ancilla bit are each convertible into the equivalent circuit 42 (see FIG. 4). A total of 12 $C^3$-NOT gates "1, 2, 7, 22, 24, 27, 29, 31, 33, 36, 38, 39" are able to use at least one clean bit. Since the equivalent circuit 42 includes three quantum gates, a total of 36 ($12 \times 3$) quantum gates are present after the conversion.

Among the $C^3$-NOT gates, those that are unable to use any clean bit are each converted into the equivalent circuit 43 (see FIG. 4). A total of four $C^3$-NOT gates "11, 14, 17, 20" are unable to use any clean bit. Since the equivalent circuit 43 includes four quantum gates, a total of 16 ($4 \times 4$) quantum gates are present after the conversion.

Among the $C^4$-NOT gates, those that are able to use at least two clean bits as ancilla bits are each convertible into the equivalent circuit 45 (see FIG. 5). A total of eight $C^4$-NOT gates "4, 5, 6, 9, 25, 30, 32, 34" are able to use at least two clean bits. Since the equivalent circuit 45 includes five quantum gates, a total of 40 ($5 \times 8$) quantum gates are present after the conversion.

Among the $C^4$-NOT gates, those that are able to use only one clean bit are each convertible into the equivalent circuit 46 (see FIG. 5). A total of two $C^4$-NOT gates "10, 23" are able to use only one clean bit. Since the equivalent circuit 46 includes six quantum gates, a total of 12 ($6 \times 2$) quantum gates are present after the conversion.

Among the $C^4$-NOT gates, those that are unable to use any clean bit are each converted into the equivalent circuit 47 (see FIG. 5). A total of three $C^4$-NOT gates "13, 16, 18" are unable to use any clean bit. Since the equivalent circuit 47 includes eight quantum gates, a total of 24 ($8 \times 3$) quantum gates are present after the conversion.

As a result of converting the quantum circuit 48 into a quantum gate constructed with only basic quantum gates, a total of 139 (= 11 + 36 + 16 + 40 + 12 + 24) basic quantum gates are present.

If clean bits are not managed, as described earlier, every $C^3$-NOT gate is converted into the equivalent circuit 43, and every $C^4$-NOT gate is converted into the equivalent circuit 47. In this case, a total of 179 basic quantum gates are included in the quantum circuit after the conversion. That is, by managing clean bits, the number of quantum gates in the quantum circuit is reduced from 179 to 139.

Next, a process of converting a quantum gate other than the basic quantum gates into an equivalent circuit will be described in detail.

First, applicable conversion methods for conversion into an equivalent circuit depending on the number of usable clean ancilla bits and the number of usable dirty ancilla bits will be described.

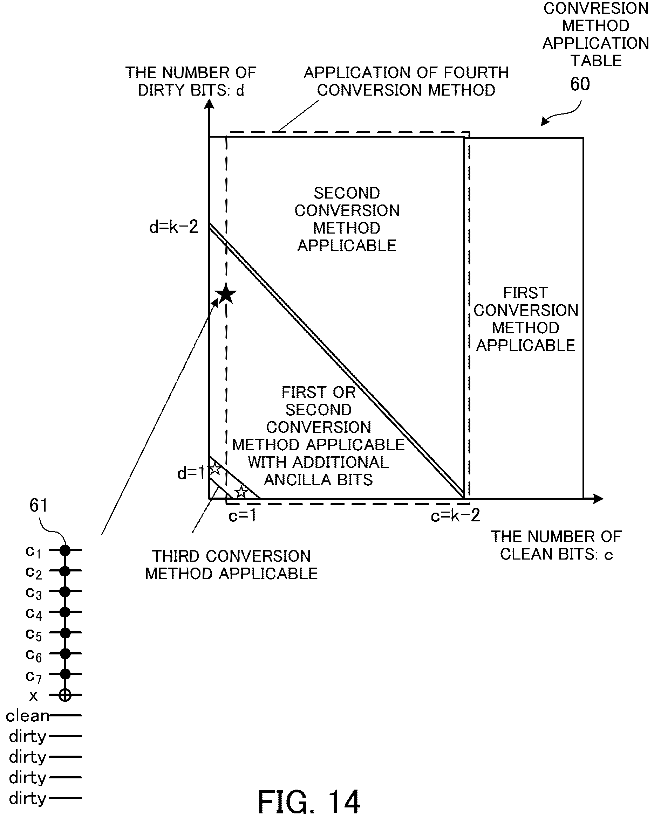

FIG. 14 illustrates an example of the correspondence relationship between the number of usable ancilla bits and applicable conversion methods. A conversion method application table 60 indicates the applicable conversion methods according to the number of clean bits and the number of dirty bits. In the conversion method application table 60, the horizontal axis represents the number of usable clean bits, and the vertical axis represents the number of usable dirty bits.

A first conversion method is to perform conversion into an equivalent circuit with the smallest number of quantum gates. The first conversion method converts a $C^k$-NOT gate into (2k - 3) $C^2$-NOT gates using (k - 2) clean ancilla bits. The first conversion method results in a smaller number of quantum gates after conversion than the other conversion methods described later. However, the first conversion method is applicable only when (k - 2) or more clean bits are usable. Therefore, the quantum gate conversion unit 130 applies the first conversion method when (k - 2) clean ancilla bits are usable.

A second conversion method is to perform conversion into an equivalent circuit using clean or dirty ancilla bits. The second conversion method converts a $C^k$-NOT gate into (4k - 8) $C^2$-NOT gates using (k - 2) ancilla bits. The second conversion method is applicable even when all the ancilla bits are dirty, and therefore has high versatility. However, if the number of ancilla bits is insufficient, the addition of qubits is needed for use as ancilla bits until the number of ancilla bits (the total of clean bits and dirty bits) reaches (k - 2). In addition, the second conversion method results in (2k - 5) more gates than the first conversion method.

A third conversion method is to perform conversion into an equivalent circuit using one ancilla bit (either a clean bit or a dirty bit). The third conversion method enables conversion using a small number of ancilla bits. However, the third conversion method results in 4k to 6k more gates than the first or second conversion method.

A fourth conversion method is a method that is able to compensate for the drawbacks of the first, second, and third conversion methods. The fourth conversion method enables conversion into an equivalent circuit with a smaller number of quantum gates by effectively using usable ancilla bits, provided that at least one clean bit is usable. The fourth conversion method is applicable without adding any ancilla bits even when the number of clean bits is less than (k - 2), and thus compensates for the drawback of the first conversion method that uses (k - 2) or more clean bits. The fourth conversion method enables conversion into an equivalent circuit with a smaller number of quantum gates than those produced by the second and third conversion methods, and thus compensates for the drawback of the second and third conversion methods in which the number of quantum gates increases.

In the case where (k - 2) or more clean bits are usable, the first conversion method is applicable to perform conversion to an equivalent circuit with the smallest number of quantum gates. Therefore, the fourth conversion method is effective in cases where the number of clean bits c satisfies "$1 \leq c \leq (k - 3)$".

For example, assume now that one clean bit (c = 1) and four dirty bits (d = 4) are usable as ancilla bits when a $C^7$-NOT gate 61 is converted into an equivalent circuit.

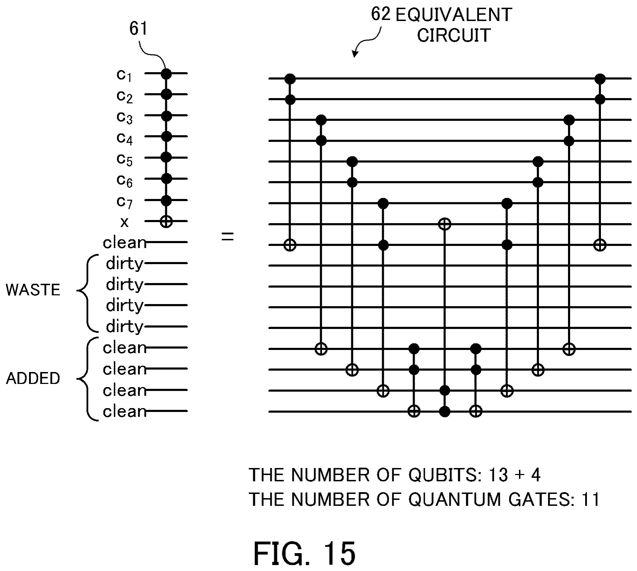

FIG. 15 illustrates an example of an equivalent circuit of a $C^7$-NOT gate according to the first conversion method. The $C^7$-NOT gate 61 uses seven control qubits. In this case, the number of clean bits used in the first conversion method is five. Therefore, there is a shortage of four clean bits. That is, in order to convert the $C^7$-NOT gate 61 with the first conversion method, four clean bits needs to be added.

In the case where five clean bits are usable as ancilla bits, an equivalent circuit 62 is generated by the first conversion method. Sets of control qubits are formed sequentially from the highest-order control qubit, and for each set, the result of a $C^2$-NOT gate is set to a clean bit. The clean bit to which the operation result is set is then reused as a control qubit, and the subsequent gate operations are repeated in the same manner. Then, by executing the sixth $C^2$-NOT gate, the same operation as that performed by the $C^7$-NOT gate 61 is performed on the target qubit.

The last five $C^2$-NOT gates are quantum gates that clean the ancilla bits that are initially clean bits. With these $C^2$-NOT gates, the equivalent circuit 62 becomes equivalent to the $C^7$-NOT gate 61 including the states of the ancilla bits after the gate operations.

In the equivalent circuit 62, dirty bits are not used. Therefore, the dirty bits are a waste. In addition, since clean bits are added, the number of qubits used increases. In addition, the first conversion method is applied under the condition that 17 qubits are usable. If the quantum computer 200 does not have a sufficient number of additional qubits usable, the first conversion method is not applicable.

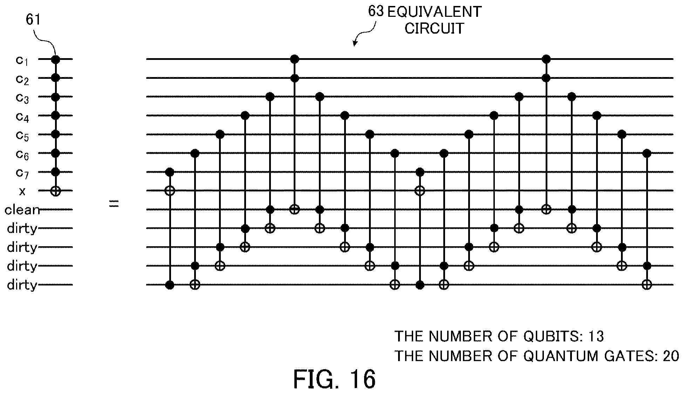

FIG. 16 illustrates an example of an equivalent circuit of the $C^7$-NOT gate according to the second conversion method. When the second conversion method is applied to the $C^7$-NOT gate 61, (k - 2), i.e., five ancilla bits are used. Therefore, the $C^7$-NOT gate 61 is convertible into an equivalent circuit 63 by the second conversion method, treating the clean bit the same as dirty bits.

In the equivalent circuit 63, the first five $C^2$-NOT gates each use a set of an ancilla bit (clean bit or dirty bit) and a control qubit in the $C^7$-NOT gate 61 as the control qubits in the $C^2$-NOT gate. Each of the first five $C^2$-NOT gates uses different control qubits. The target qubit in the first $C^2$-NOT gate is the target qubit in the $C^7$-NOT gate 61. The target qubit in each of the second to fifth $C^2$-NOT gates is the ancilla bit used as a control qubit in the preceding $C^2$-NOT gate. The control qubits in the sixth $C^2$-NOT gate are control qubits that are not used in any one of the first five $C^2$-NOT gates among the control qubits in the $C^7$-NOT gate 61. The target in the sixth $C^2$-NOT gate is the ancilla bit used as a control qubit in the fifth $C^2$-NOT gate.

The seventh to the eleventh $C^2$-NOT gates are obtained by arranging the first to the fifth $C^2$-NOT gates in reverse order. The twelfth to the twentieth $C^2$-NOT gates are obtained by arranging the second to the tenth $C^2$-NOT gates in reverse order.

By executing the eleventh $C^2$-NOT gate of the equivalent circuit 63, the same operation as that performed by the $C^7$-NOT gate 61 is applied to the target qubit. The last nine $C^2$-NOT gates are quantum gates that restore the original states of the ancilla bits. With these $C^2$-NOT gates, the equivalent circuit 63 becomes equivalent to the $C^7$-NOT gate 61, including the states of the ancilla bits after the gate operations.

Since the second conversion method treats the clean bit the same as dirty bits, the clean bit is not used effectively. Therefore, although the number of qubits used is reduced to 13, the number of quantum gates in the equivalent circuit 63 increases to 20.

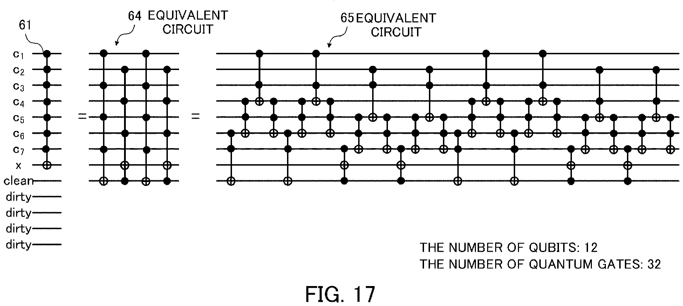

FIG. 17 illustrates an example of an equivalent circuit of the $C^7$-NOT gate according to the third conversion method. When the third conversion method is applied to the $C^7$-NOT gate 61, one ancilla bit is used. In the third conversion method, the $C^7$-NOT gate 61 is first decomposed into four $C^4$-NOT gates using one ancilla bit (a clean bit in the example of FIG. 17), thereby generating an equivalent circuit 64. Then, each of the $C^4$-NOT gates included in the equivalent circuit 64 is converted into the equivalent circuit 47 (see FIG. 5), thereby generating an equivalent circuit 65 including only $C^2$-NOT gates.

In the third conversion method, since the clean bit is treated as a dirty bit, the clean bit is not used effectively. In addition, since only one ancilla bit is used, many dirty bits are also not used effectively. Therefore, although the number of qubits used is reduced to 13, the number of quantum gates in the equivalent circuit 65 increases to 32.

To deal with this, the quantum gate conversion unit 130 minimizes the number of gates by using as many given clean bits and dirty bits as possible. In particular, in the case where the number of clean bits c is "c = 1, ..., k - 1", the quantum gate conversion unit 130 uses the fourth conversion method to perform conversion into an equivalent circuit with a smaller number of quantum gates.

The quantum gate conversion unit 130 generates, from the group of k control qubits $C = \{c_1, ..., c_k\}$ in the $C^k$-NOT, sets of two qubits that are equal in number to the number of clean bits, in the same manner as in the first conversion method. The quantum gate conversion unit 130 adds a $C^2$-NOT gate that uses the two qubits of a set as the control qubits and a clean bit as the target qubit, to the equivalent circuit. The quantum gate conversion unit 130 then adds the clean bit used as the target qubit in the added $C^2$-NOT gate, to the group of control qubits C. In the case where there are (k - 2) or more clean bits, this conversion method becomes equivalent to the first conversion method. This conversion policy is the basic policy of the fourth conversion method.

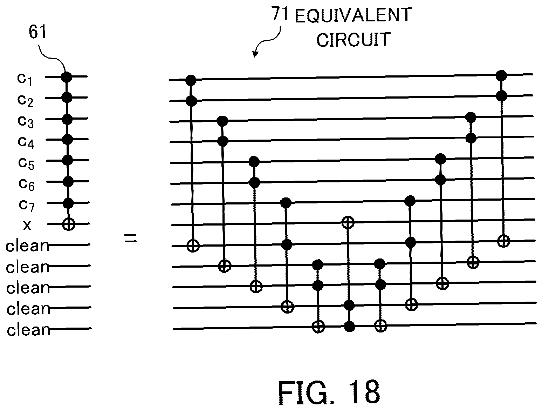

FIG. 18 illustrates an example of an equivalent circuit of the $C^7$-NOT gate according to the basic policy of the fourth conversion method. As illustrated in FIG. 18, in the case where k = 7 and the number of clean bits is "c = 5", the $C^7$-NOT gate 61 is converted into an equivalent circuit 71 including 11 $C^2$-NOT gates, as in the first conversion method (see FIG. 15).

In the case where the number of clean bits is less than (k - 5), the quantum gate conversion unit 130 gradually decreases the number of control qubits in the $C^k$-NOT gate 61. In this case, if the control qubits are not divided into groups appropriately, the number of quantum gates is not reduced sufficiently in the converted quantum circuit.

For example, it is conceivable to perform conversion to an equivalent circuit that includes $C^2$-NOT gates using sets of control qubits equal in number to the number of clean bits and a $C^k$-NOT gate using control qubits that are not used in these $C^2$-NOT gates.

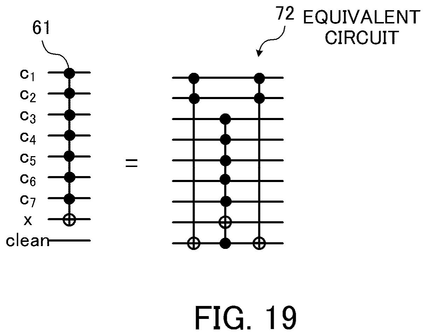

FIG. 19 illustrates a first example of an equivalent circuit of the $C^7$-NOT gate according to the fourth conversion method in the case where there are only less than (k - 2) clean bits. In the example of FIG. 19, c = 1 for k = 7. In this case, the $C^7$-NOT gate 61 is converted into an equivalent circuit 72 including two $C^2$-NOT gates and one $C^6$-NOT gate.

Here, in the case where the central $C^6$-NOT gate is further converted into an equivalent circuit, only two dirty bits ($c_1$ and $c_2$) are available as usable ancilla bits. Therefore, only the third conversion method is applicable to the conversion of the $C^6$-NOT gate into an equivalent circuit. The third conversion method, when applied, converts the $C^6$-NOT gate into 24 $C^2$-NOT gates. As a result, the $C^7$-NOT gate 61 is converted into a total of 26 $C^2$-NOT gates. Thus, the application of the third conversion method results in an increased number of gates.

To deal with this, the quantum gate conversion unit 130 divides the group of control qubits in a $C^k$-NOT gate to be converted, into a plurality of partial groups so that the second conversion method becomes applicable to the central $C^k$-NOT gate after decomposition. By doing so, the number of quantum gates is reduced in the finally generated equivalent circuit.

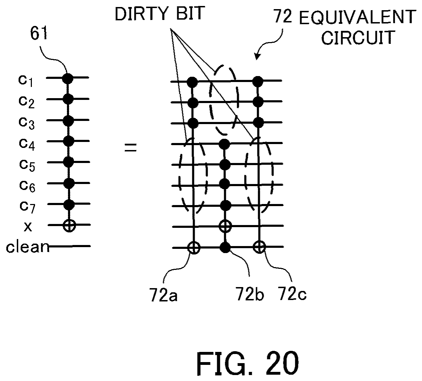

FIG. 20 illustrates a second example of an equivalent circuit of the $C^7$-NOT gate according to the fourth conversion method in the case where there are only less than (k - 2) clean bits. In the example of FIG. 20, in the case of c = 1 for k = 7, the $C^7$-NOT gate 61 is converted into an equivalent circuit 72 including two $C^3$-NOT gates 72a and 72c and one $C^5$-NOT gate 72b.

In converting the $C^3$-NOT gate 72a into an equivalent circuit, the control qubits $\{c_4, c_5, c_6\}$ are usable as dirty ancilla bits. Therefore, the $C^3$-NOT gate 72a is convertible into four $C^2$-NOT gates using the second conversion method.

In converting the $C^5$-NOT gate 72b into an equivalent circuit, the control qubits $\{c_1, c_2, c_3\}$ are usable as dirty ancilla bits. Therefore, the $C^5$-NOT gate 72b is convertible into 12 $C^2$-NOT gates using the second conversion method.

In converting the $C^3$-NOT gate 72c into an equivalent circuit, the control qubits $\{c_4, c_5, c_6\}$ are usable as dirty ancilla bits. Therefore, the $C^3$-NOT gate 72c is convertible into four $C^2$-NOT gates using the second conversion method.

As described above, by first generating $C^3$-NOT gates instead of generating $C^2$-NOT gates, a $C^5$-NOT gate is

generated as the central $C^k$-NOT gate. Thus, when each $C^k$-NOT gate in the equivalent circuit 72 is converted into an equivalent circuit, (k - 2) or more ancilla bits become usable. As a result, the $C^7$-NOT gate is convertible into a total of 20 $C^2$-NOT gates by the second conversion method.

In the case where two or more clean bits c are usable, the quantum gate conversion unit 130 decomposes a $C^k$-NOT gate into (2c + 1) quantum gates. At this time, the quantum gate conversion unit 130 determines (c + 1) integers "$k_1$, ..., $k_{c+1}$". The quantum gate conversion unit 130 then decomposes the $C^k$-NOT gate into $C^{k\_1}$-NOT, ..., $C^{k\_c}$-NOT, $C^{k\_c+1}$-NOT, $C^{k\_c}$-NOT, ... , and $C^{k\_1}$-NOT. The characters following the superscript "k\_" represents a subscript of k. For example, superscripts "k\_1, ..., k\_c+1" represent superscripted integers "$k_1$, ..., $k_{c+1}$", respectively.

With respect to integers each indicating the number of control qubits for a quantum gate to be generated by decomposition (the number of post-decomposition control qubits), the quantum gate conversion unit 130 determines integers satisfying the following two conditions among integers satisfying $k_1 \geq k_2 \geq ... \geq k_c$. Note that $k_{c+1}$ satisfies the following equation.

$$k_{c+1} = k - \sum_{i=1}^{c} (k_i - 1) \qquad (1)$$

[Condition 1] The second conversion method is applicable to the $c^{k\_c+1}$-NOT gate. That is, ($k_{c+1}$ - 2) dirty bits are ensured.

[Condition 2] $1 \leq i < j \leq c$ satisfying $k_i > (c - i + 2)$ and $k_j < (c - j + 2)$ does not exist.

At this time, the quantum gate conversion unit 130 are able to use the (i + 1)-th to the c-th clean bits when converting the $c^{k\_i}$-NOT gate, where $1 \leq i \leq (c - 1)$, into $C^2$-NOT gates. Further, a sufficient number of dirty bits are ensured when the $c^{k\_i}$-NOT gate, where $1 \leq i \leq (c - 1)$, is converted into the $C^2$-NOT gates. Therefore, the above-described "basic policy plus second conversion method" is applicable.

Condition 1 is set to ensure as many clean bits as possible in the $C^{k\_i}$-NOT gate using many control qubits.

Condition 2 is set to use clean bits without excess or deficiency. If $1 \leq i < j \leq c$ satisfying $k_i > (c - i + 2)$ and $k_j < (c - j + 2)$ exists, it is confirmed that clean bits are used effectively in the new decomposition with $k_i \leftarrow (k_i - 1)$ and $k_j \leftarrow (k_j + 1)$, particularly in the conversion of the $C^{k\_j}$-NOT gate, compared to the original decomposition. That is, if Condition 2 is not satisfied, the quantum gate conversion unit 130 is able to reduce the number of quantum gates by four, compared to the original decomposition, by changing the numbers of post-decomposition control qubits to $k_i \leftarrow (k_i - 1)$ and $k_j \leftarrow (k_j + 1)$.

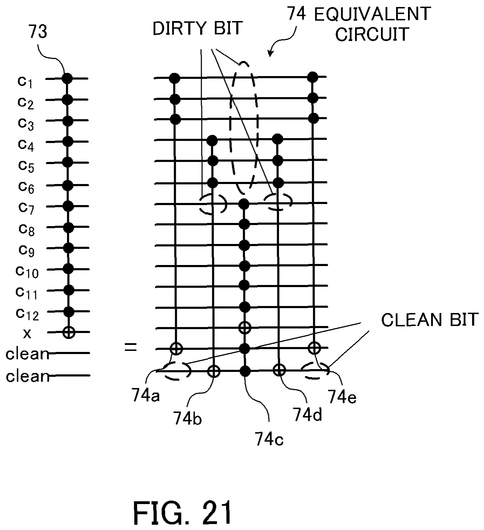

FIG. 21 illustrates an example of decomposition according to the fourth conversion method in the case of c = 2. The example of FIG. 21 assumes that a $C^{12}$-NOT gate 73 is converted into an equivalent circuit 74. The number of clean bits c is 2 (k = 12, c = 2). In this case, the integers each indicating the number of post-decomposition control qubits for a $C^{k\_i}$-NOT gate obtained by decomposition according to the fourth conversion method are "$k_1 = k_2 = 3, k_3 = 8$".

Since "$k_1 = 3$", the first quantum gate in the equivalent circuit 74 is a $C^3$-NOT gate 74a. Since "$k_2 = 3$", the second quantum gate in the equivalent circuit 74 is a $C^3$-NOT gate 74b. Since "$k_3 = 8$", the third quantum gate (central quantum gate) in the equivalent circuit 74 is a $C^8$-NOT gate 74c. Since "$k_2 = 3$", the fourth quantum gate in the equivalent circuit 74 is a $C^3$-NOT gate 74d. Since "$k_1 = 3$", the fifth quantum gate in the equivalent circuit 74 is a $C^3$-NOT gate 74e.

In the conversion of each of the $C^3$-NOT gates 74a and 74e into an equivalent circuit, one clean bit is usable as an ancilla bit. The fourth conversion method is applicable to the $C^3$-NOT gates 74a and 74e. Therefore, each of the $C^3$-NOT gates 74a and 74e is convertible into the equivalent circuit 42 (see FIG. 4) including three $C^2$-NOT gates using the clean bit, based on the basic policy of the fourth conversion method. In the conversion of each of the $C^3$-NOT gates 74b and 74d into an equivalent circuit, one dirty bit is usable as an ancilla bit. Therefore, each of the $C^3$-NOT gates 74b and 74d is convertible into the equivalent circuit 43 (see FIG. 4) including four $C^2$-NOT gates using the dirty bit. In the conversion of the $C^8$-NOT gate 74c into an equivalent circuit, six dirty bits are usable as ancilla bits. Therefore, the $C^8$-NOT gate 74c is convertible into 24 $C^2$-NOT gates by the second conversion method.

As described above, the quantum gate conversion unit 130 is able to convert the $C^{12}$-NOT gate 73 into an equivalent circuit including a total of 38 $C^2$-NOT gates, by converting each $C^k$-NOT gate in the equivalent circuit 74 into an equivalent circuit.

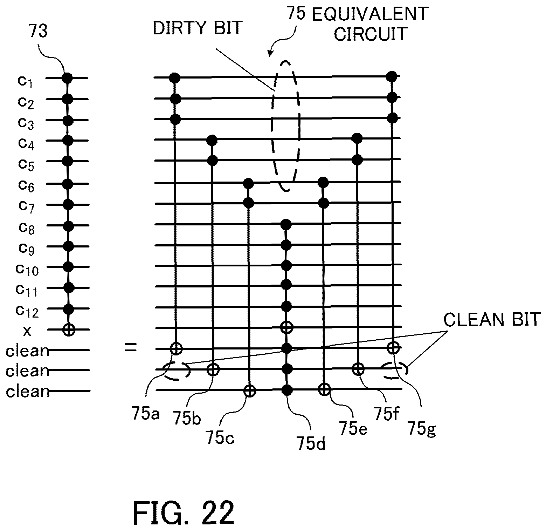

FIG. 22 illustrates an example of decomposition according to the fourth conversion method in the case of c = 3. The example of FIG. 22 assumes that the $C^{12}$-NOT gate 73 is converted into an equivalent circuit 75. The number of clean bits c is 3 (k = 12, c = 3). In this case, integers each indicating a decomposition position based on the fourth conversion method are "$k_1 = 3, k_2 = k_3 = 2, k_3 = 8$".

Since "$k_1 = 3$", the first quantum gate in the equivalent circuit 75 is a $C^3$-NOT gate 75a. Since "$k_2 = 2$", the second quantum gate in the equivalent circuit 75 is a $C^2$-NOT gate 75b. Since "$k_3 = 2$", the third quantum gate in the equivalent circuit 75 is a $C^2$-NOT gate 75c. Since "$k_4 = 8$", the fourth quantum gate (central quantum gate) in the equivalent circuit 75 is

a $C^8$-NOT gate 75d. Since "$k_3 = 2$", the fifth quantum gate in the equivalent circuit 75 is a $C^2$-NOT gate 75e. Since "$k_2 = 2$", the sixth quantum gate in the equivalent circuit 75 is a $C^2$-NOT gate 75f. Since "$k_1 = 3$", the seventh quantum gate in the equivalent circuit 75 is a $C^3$-NOT gate 75g.

In the conversion of each of the $C^3$-NOT gates 75a and 75g into an equivalent circuit, one clean bit is usable as an ancilla bit. Therefore, each $C^3$-NOT gate 75a and 75g is convertible into the equivalent circuit 42 (see FIG. 4) including three $C^2$-NOT gates using the clean bit. In the conversion of the $C^8$-NOT gate 75d to an equivalent circuit, six dirty bits are usable as ancilla bits. Therefore, the $C^8$-NOT gate 75d is convertible into 24 $C^2$-NOT gates by the second conversion method.

As described above, the quantum gate conversion unit 130 is able to convert the $C^{12}$-NOT gate 73 into an equivalent circuit including a total of 34 $C^2$-NOT gates, by converting each $C^k$-NOT gate in the equivalent circuit 75 into an equivalent circuit.

Next, the functions of the quantum gate conversion unit 130 for implementing the above conversion process will be described.

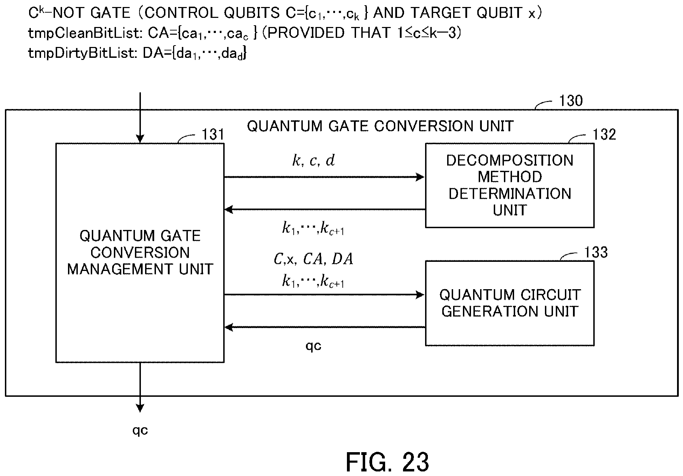

FIG. 23 illustrates an example of functions of the quantum gate conversion unit. The quantum gate conversion unit 130 includes a quantum gate conversion management unit 131, a decomposition method determination unit 132, and a quantum circuit generation unit 133.

The quantum gate conversion management unit 131 converts a received $C^k$-NOT gate into an equivalent circuit "qc" in cooperation with the decomposition method determination unit 132 and the quantum circuit generation unit 133. For example, the quantum gate conversion management unit 131 receives information indicating the $C^k$-NOT gate, "tmpCleanBitList", and "tmpDirtyBitList". The information indicating the $C^k$-NOT gate includes a list of control qubits C = $\{c_1, ..., c_k\}$ and the identification number "x" of the target qubit. "tmpCleanBitList" is a list "CA = $\{ca_1, ..., ca_c\}$" of qubits usable as clean bits. Here, c is the number of clean bits ($1 \leq c \leq (k-3)$). "tmpDirtyBitList" is a list "DA = $\{da_1, ..., da_d\}$" of qubits usable as dirty bits. Here, d is the number of dirty bits.

The decomposition method determination unit 132 determines, based on the values of k, c, and d, the number of control qubits $(k_1, ..., k_{c+1})$ for the quantum gates after the decomposition of the $C^k$-NOT gate such that the final number of $C^2$-NOT gates is minimized.

The quantum circuit generation unit 133 receives the number of control qubits $(k_1, ..., k_{c+1})$ for each quantum gate after decomposition, determined by the decomposition method determination unit 132, and outputs the equivalent circuit "qc" of the $C^k$-NOT gate (including only $C^2$-NOT gates) .

Next, a procedure for the quantum gate conversion process performed by the quantum gate conversion unit 130 will be described in detail.

FIG. 24 is a flowchart illustrating an example procedure for the quantum gate conversion process. Hereinafter, the process of FIG. 24 will be described in order of step numbers.

[Step S301] The quantum gate conversion management unit 131 determines whether the condition that the number of clean bits c is zero (c = 0) and the number of dirty bits d is one or more ($d \geq 1$) is satisfied. If the condition is satisfied, the quantum gate conversion management unit 131

advances the process to step S302. If the condition is not satisfied, the quantum gate conversion management unit 131 advances the process to step S303.

[Step S302] The quantum gate conversion management unit 131 instructs the quantum circuit generation unit 133 to generate a quantum circuit equivalent to the $C^k$-NOT gate to be converted. The quantum circuit generation unit 133 generates an equivalent circuit "qc" of the $C^k$-NOT gate to be converted, by the third conversion method. Upon receiving the equivalent circuit "qc" from the quantum circuit generation unit 133, the quantum gate conversion management unit 131 advances the process to step S307.

[Step S303] The quantum gate conversion management unit 131 determines whether the condition that the number of clean bits c is equal to or greater than $(k-2)$ ($c \geq (k-2)$) is satisfied. If the condition is satisfied, the quantum gate conversion management unit 131 advances the process to step S304. If the condition is not satisfied, the quantum gate conversion management unit 131 advances the process to step S305.

[Step S304] The quantum gate conversion management unit 131 instructs the quantum circuit generation unit 133 to generate a quantum circuit equivalent to the $C^k$-NOT gate to be converted. The quantum circuit generation unit 133 generates an equivalent circuit "qc" of the $C^k$-NOT gate to be converted, by the first conversion method. Upon receiving the equivalent circuit "qc" from the quantum circuit generation unit 133, the quantum gate conversion management unit 131 advances the process to step S307.

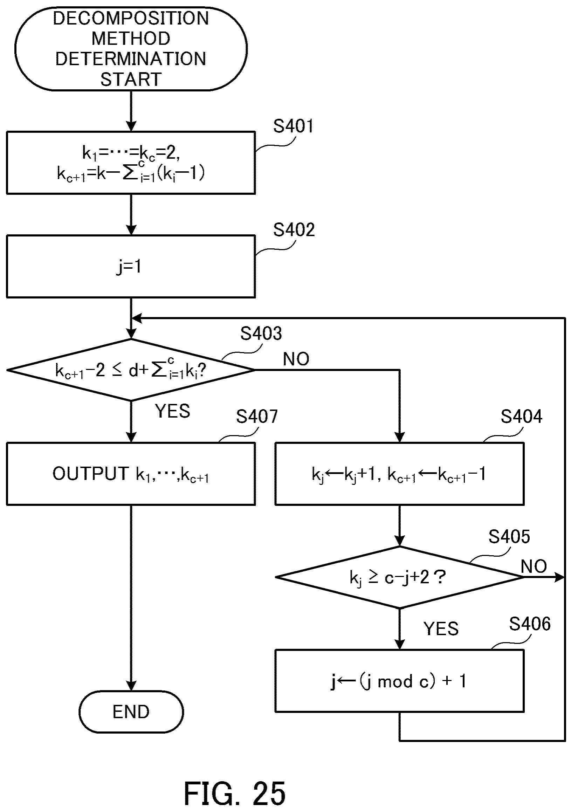

[Step S305] The quantum gate conversion management unit 131 instructs the decomposition method determination unit 132 to determine a decomposition method. The decomposition method determination unit 132 determines the number of post-decomposition control qubits for each $C^{k\_i}$-NOT gate to be generated by decomposing the $C^k$-NOT gate, in response to the instruction. The quantum gate conversion management unit 131 acquires a set of integers each indicating the number of post-decomposition control qubits, from the decomposition method determination unit 132. The details of the decomposition method determination process will be described later (see FIG. 25).

[Step S306] The quantum gate conversion management unit 131 instructs the quantum circuit generation unit 133 to generate a quantum circuit equivalent to the $C^k$-NOT gate using the fourth conversion method. The quantum circuit generation unit 133 generates an equivalent circuit "qc" of the $C^k$-NOT gate by the fourth conversion method. The quantum gate conversion management unit 131 acquires the equivalent circuit "qc" from the quantum circuit generation unit 133.

[Step S307] The quantum gate conversion management unit 131 outputs the equivalent circuit "qc" as the equivalent circuit of the $C^k$-NOT gate to be converted.

As described above, in the case where the first conversion method is applicable, the $C^k$-NOT gate is converted into an equivalent circuit by the first conversion method. If the applicable conversion method is limited to the third conversion method, the $C^k$-NOT gate is converted into an equivalent circuit by the third conversion method. Otherwise, the $C^k$-NOT gate is converted into an equivalent circuit by the fourth conversion method.

Next, a procedure for the decomposition method determination process will be described in detail.

FIG. 25 is a flowchart illustrating an example procedure for the decomposition method determination process. Hereinafter, the process of FIG. 25 will be described in order of step numbers.

[Step S401] The decomposition method determination unit 132 performs initial setting. For example, the decomposition method determination unit 132 sets $k_1 = k_2 = ... = k_c = 2$. In addition, the decomposition method determination unit 132 sets $k_{c+1}$ as in Equation (1). In the case where "$k_1, ..., k_c$" have an initial value "2", "$k_i - 1$" on the right-hand side of Equation (1) is 1 for each i, and therefore the right-hand side becomes "k - c". That is, the initial value of $k_{c+1}$ is a value obtained by subtracting the number of clean bits c from the number of control qubits k in the $C^k$-NOT gate to be converted.

[Step S402] The decomposition method determination unit 132 initializes a variable j to "1" (j = 1).

[Step S403] The decomposition method determination unit 132 makes an end determination based on whether the following Equation (2) is satisfied.

$$k_{c+1} - 2 \leq d + \sum_{i=1}^{c} k_i \qquad (2)$$

Equation (2) indicates the condition that the number of qubits usable as dirty ancilla bits at the time of execution of the $C^{k\_c+1}$-NOT gate is ($k_{c+1}$ - 2) or more. This condition is needed to apply the second conversion method. The number of qubits usable as dirty ancilla bits at the time of execution of the $C^{k\_c+1}$-NOT gate is the sum of the number of elements included in DA and the total number of qubits used as the control qubits in the quantum gates from the $C^{k\_1}$-NOT gate to the $C^{k\_c}$-NOT gate.

If the condition in the end determination is satisfied, the decomposition method determination unit 132 advances the process to step S407. If the condition in the end determination is not satisfied, the decomposition method determination unit 132 advances the process to step S404.

[Step S404] The decomposition method determination unit 132 adds "1" to $k_j$ ($k_j \leftarrow k_j + 1$). The decomposition method determination unit 132 subtracts "1" from $k_{c+1}$ ($k_{c+1} \leftarrow k_{c+1} - 1$).

[Step S405] The decomposition method determination unit 132 determines whether $k_j$ is greater than or equal to $(c - j + 2)$ ($k_j \geq (c - j + 2)$?). If $k_j$ is greater than or equal to $(c - j + 2)$, the decomposition method determination unit 132 advances the process to step S406. If $k_j$ is less than $(c - j + 2)$, the decomposition method determination unit 132 advances the process to step S403.

Step S405 ensures that the above-described Condition 2 ($1 \leq i < j \leq c$ satisfying $k_i > (c - i + 2)$ and $k_j < (c - j + 2)$ does not exist) is satisfied. That is, if "$k_j \geq (c - j + 2)$" is not satisfied after "1" is added to $k_j$ in step S404, "1" is further added to $k_j$ unless the end determination is satisfied. When "$k_j \geq (c - j + 2)$" is satisfied, "$k_j > (c - j + 2)$" is not satisfied because no more addition is performed.

In addition, there is a case where the number of clean bits "c - j" that are usable at the time of conversion of the $C^{k\_j}$-NOT gate into an equivalent circuit is small. For example, in the case of "c - j = 0", "$k_j > (c - j + 2)$" is obtained when "$k_j = 3$" is obtained by the first addition to the initial value "$k_j = 2$" of $k_j$ in step S404. On the other hand, the number of clean bits "c - p" that are usable at the time of conversion of the $C^{k\_p}$-NOT gate ($j < p \leq c$) into an equivalent circuit is smaller than "c - j" (for example, "c - j = -1"). Therefore, for example, even if $k_p$ remains at the initial value "$k_p = 2$", "$k_p < (c - j + 2)$" is not obtained, and therefore "$k_p < (c - j + 2)$" is not satisfied.

From the above, $1 \leq j < p \leq c$ satisfying $k_j > (c - j + 2)$ and $k_p < (c - p + 2)$ does not exist. The same holds true even when j is replaced with i and p is replaced with j. Therefore, the execution of step S405 ensures that Condition 2 is satisfied. When Condition 2 is satisfied, clean bits are effectively utilized, and the number of quantum gates is reduced in the converted equivalent circuit.

[Step S406] The decomposition method determination unit 132 updates j to a value obtained by adding 1 to the remainder obtained by dividing j by c (j ← (j mod c) + 1). Thereafter, the decomposition method determination unit 132 advances the process to step S403.

[Step S407] The decomposition method determination unit 132 outputs "$k_1, ..., k_{c+1}$", and ends the decomposition method determination process. The output "$k_1, ..., k_{c+1}$" indicates that the number of quantum gates after decomposition is (2c + 1), and the respective numbers of control qubits are "$k_1, ..., k_c, k_{c+1}, k_c, ..., k_1$".

In this way, the number of control qubits for each of the $C^{k}\_1$-NOT gate, the $C^{k}\_2$-NOT gate, ... after the decomposition is determined. By decomposing the $C^k$-NOT gates determined to be converted into quantum gates of the determined sizes, the number of quantum gates is reduced in the finally generated equivalent circuit.

Next, a procedure for the quantum circuit generation process using the fourth conversion method will be described in detail.

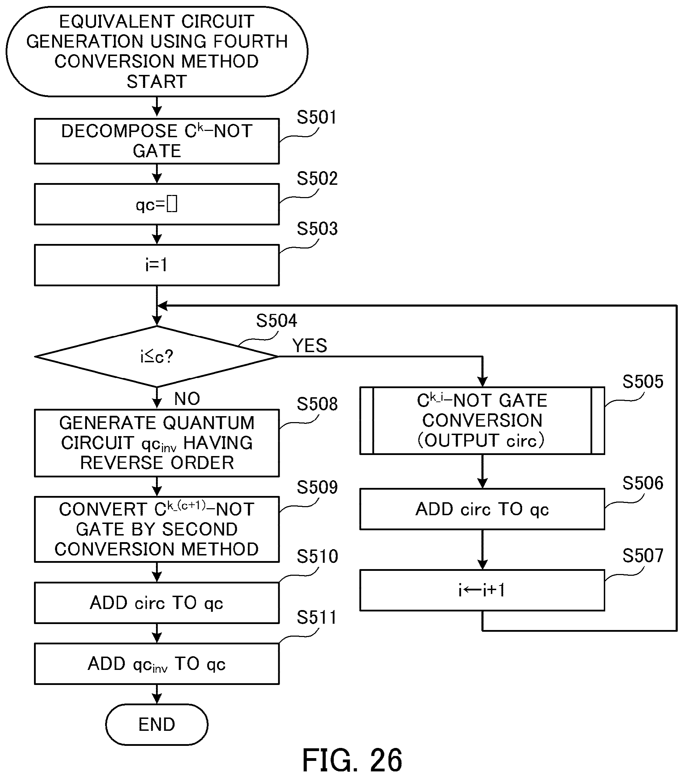

FIG. 26 is a flowchart illustrating an example procedure for the equivalent circuit generation process using the fourth conversion method. Hereinafter, the process of FIG. 26 will be described in order of step numbers.

[Step S501] The quantum circuit generation unit 133 decomposes a $C^k$-NOT gate according to a set of integers "$k_1, ..., k_c, k_{c+1}$" each indicating the number of post-decomposition control qubits. Through the decomposition process, a $C^k\_1$-NOT gate, ..., a $C^k\_c$-NOT gate, a $C^k\_{c+1}$-NOT gate, ..., a $C^k\_c$-NOT gate, ..., and a $C^k\_1$-NOT gate are generated.

[Step S502] The quantum circuit generation unit 133 generates an empty equivalent circuit "qc" (qc = []).

[Step S503] The quantum circuit generation unit 133 sets the variable i to an initial value "1".

[Step S504] The quantum circuit generation unit 133 determines whether the value of the variable i is less than or equal to the number of clean bits c. If the value of the variable i is less than or equal to the number of clean bits c, the quantum circuit generation unit 133 advances the process to step S505. If the value of the variable i exceeds the number of clean bits c, the quantum circuit generation unit 133 advances the process to step S508.

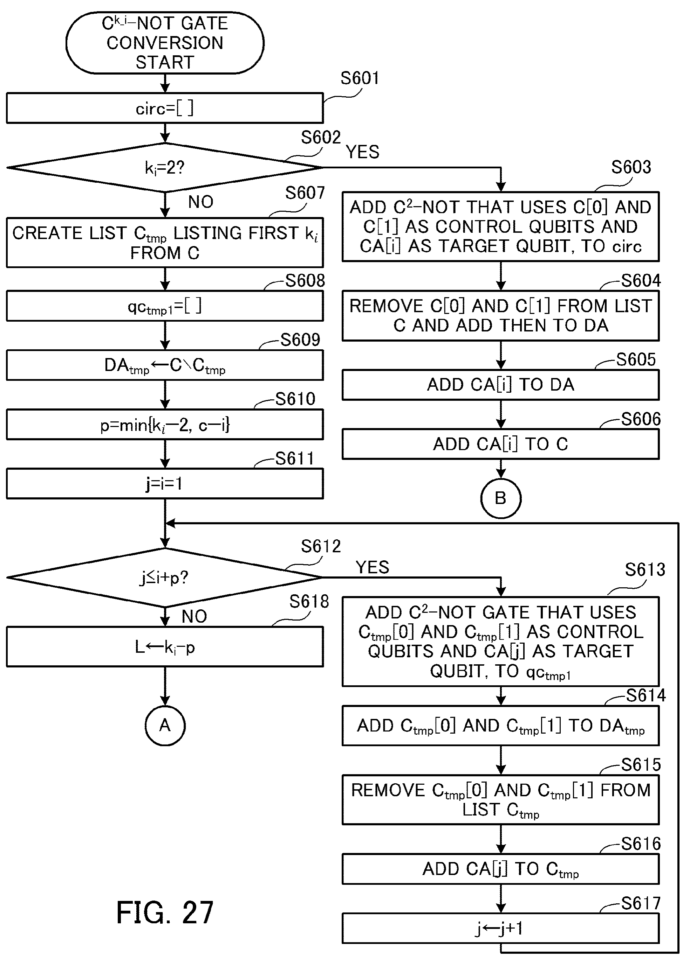

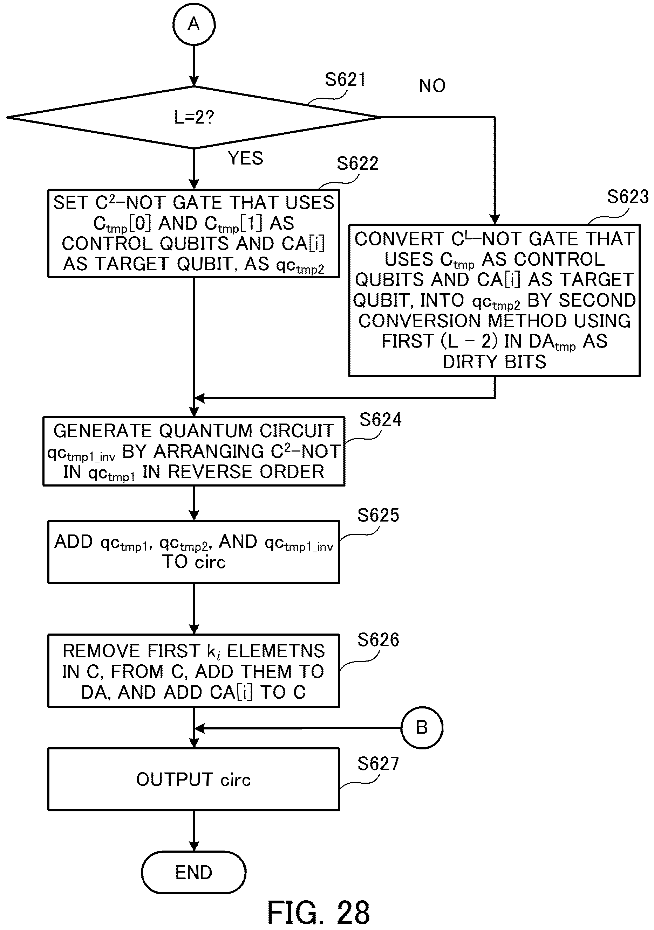

[Step S505] The quantum circuit generation unit 133 performs a process ($C^k\_i$-NOT gate conversion process) of converting a $C^k\_i$-NOT gate (the i-th quantum gate after decomposition) into an equivalent circuit using $C^2$-NOT gates. The equivalent circuit generated by the conversion process is referred to as "circ". The details of the $C^k\_i$-NOT gate conversion process will be described later (see FIGS. 27 and 28). During the $C^k\_i$-NOT gate conversion process, qubits used as the control qubits in the $C^k\_i$-NOT gate are removed from the control qubit list C.

[Step S506] The quantum circuit generation unit 133 adds the equivalent circuit "circ" to the equivalent circuit "qc".

[Step S507] The quantum circuit generation unit 133 adds 1 to the variable i (i ← i + 1). Thereafter, the quantum circuit generation unit 133 advances the process to step S504.

[Step S508] The quantum circuit generation unit 133 generates a quantum circuit "$qc_{inv}$" by arranging the quantum gates included in the equivalent circuit "qc" in reverse order.

[Step S509] The quantum circuit generation unit 133 converts the $C^k\_{(c+1)}$-NOT gate, which is the central quantum gate after the decomposition, into an equivalent circuit using $C^2$-NOT gates by the second conversion method. The control qubits in the $C^k\_{(c+1)}$-NOT gate are the qubits left in the control qubit list C. The target qubit in the $C^k\_{(c+1)}$-NOT gate is the same as the target qubit x in the $C^k$-NOT gate to be converted.

For example, assume that the quantum circuit generation unit 133 sets the number of elements L included in the control qubit list C to "$L = k_{c+1}$". The quantum circuit generation unit 133 converts the $C^k\_{(c+1)}$-NOT gate into an equivalent circuit by the second conversion method using the first two dirty bits included in DA as ancilla bits. The quantum circuit generation unit 133 sets the equivalent circuit generated by the conversion as "circ".

[Step S510] The quantum circuit generation unit 133 adds the equivalent circuit "circ" generated in step S509 to the equivalent circuit "qc".

[Step S511] The quantum circuit generation unit 133 adds the quantum circuit "$qc_{inv}$" generated in step S508 to the equivalent circuit "qc".

In this way, each of the quantum gates after the decomposition is converted into an equivalent circuit including only $C^2$-NOT gates. As a result, the equivalent circuit "qc" of the original $C^k$-NOT gate to be converted is generated.

FIG. 27 is a flowchart (1/2) illustrating an example procedure for the $C^k\_i$-NOT gate conversion process. Hereinafter, the process of FIG. 27 will be described in order of step numbers.

[Step S601] The quantum circuit generation unit 133 sets the equivalent circuit "circ" to a blank (circ = []).

[Step S602] The quantum circuit generation unit 133 determines whether $k_i$ is "2" ($k_i$ = 2?). If $k_i$ is "2", the quantum circuit generation unit 133 advances the process to step S603. If $k_i$ is not "2", the quantum circuit generation unit 133 advances the process to step S607.

[Step S603] The quantum circuit generation unit 133 adds, to the equivalent circuit "circ", a $C^2$-NOT gate that uses the first two qubits (C[0] and C[1]) in C as the control qubits and the i-th qubit (CA[i]) in CA as the target qubit.

[Step S604] The quantum circuit generation unit 133 removes, from C, the control qubits (the first two qubits in C) used in the $C^2$-NOT gate added to the equivalent circuit "circ". Then, the quantum circuit generation unit 133 adds the qubits to DA.

[Step S605] The quantum circuit generation unit 133 adds CA[i], which is the target qubit in the $C^2$-NOT gate

added to the equivalent circuit "circ", to DA.

[Step S606] The quantum circuit generation unit 133 adds CA[i], which is the target qubit in the $C^2$-NOT gate added to the equivalent circuit "circ", to C. Thereafter, the quantum circuit generation unit 133 advances the process to step S627 (see FIG. 28).

[Step S607] The quantum circuit generation unit 133 creates a list $C_{tmp}$ listing the first $k_i$ quantum gates from C.

[Step S608] The quantum circuit generation unit 133 creates an empty quantum circuit "$qc_{tmp1}$" ($qc_{tmp1}$ = []).

[Step S609] The quantum circuit generation unit 133 sets a list obtained by excluding the elements of $C_{tmp}$ from C as $DA_{tmp}$ ($DA_{tmp} \leftarrow C\backslash C_{tmp}$).

[Step S610] The quantum circuit generation unit 133 sets p to ($k_i$ - 2) or (c - i), whichever is smaller (p = min{$k_i$ - 2, c - i}).

[Step S611] The quantum circuit generation unit 133 initializes j and i to "1" (j = i = 1).

[Step S612] The quantum circuit generation unit 133 determines whether the value of j is less than or equal to (i + p) (j ≤ (i + p)?). If the value of j is less than or equal to (i + p), the quantum circuit generation unit 133 advances the process to step S613. If the value of j exceeds (i + p), the quantum circuit generation unit 133 advances the process to step S618.

[Step S613] The quantum circuit generation unit 133 adds, to the quantum circuit "$qc_{tmp1}$", a $C^2$-NOT gate that uses the frist two qubits ($C_{tmp}$[0], $C_{tmp}$[1]) in $C_{tmp}$ as the control qubits and the j-th qubit (CA[j]) in CA as the target qubit.

[Step S614] The quantum circuit generation unit 133 adds, to $DA_{tmp}$, the control qubits ($C_{tmp}$[0], $C_{tmp}$[1]) used in the $C^2$-NOT gate added to the quantum circuit "$qc_{tmp1}$".

[Step S615] The quantum circuit generation unit 133 removes, from $C_{tmp}$, the control qubits ($C_{tmp}$[0], $_{Ctmp}$[1]) used in the $C^2$-NOT gate added to the quantum circuit "$qc_{tmp1}$".

[Step S616] The quantum circuit generation unit 133 adds, to $C_{tmp}$, the target qubit (CA[j]) used in the $C^2$-NOT gate added to the quantum circuit "$qc_{tmp1}$".

[Step S617] The quantum circuit generation unit 133 adds 1 to the value of j (j ← j + 1). Thereafter, the quantum circuit generation unit 133 advances the process to step S612.

[Step S618] The quantum circuit generation unit 133 sets L to ($k_i$ - p) (L ← $k_i$ - p). Thereafter, the quantum circuit generation unit 133 advances the process to step S621 (see FIG. 28).

FIG. 28 is a flowchart (2/2) illustrating the example procedure for the $C^{k\_i}$-NOT gate conversion process. Hereinafter, the process of FIG. 28 will be described in order of step numbers.

[Step S621] The quantum circuit generation unit 133 determines whether L is 2 (L = 2?). If L is 2, the quantum circuit generation unit 133 advances the process to step S622. If L is not 2, the quantum circuit generation unit 133 advances the process to step S623.

[Step S622] The quantum circuit generation unit 133 sets a $C^2$-NOT gate that uses the first two qubits ($C_{tmp}$[0], $C_{tmp}$[1]) in $C_{tmp}$ as the control qubits and the i-th qubit (CA[i]) in CA as the target qubit, as an equivalent circuit "$qc_{tmp2}$". Thereafter, the quantum circuit generation unit 133 advances the process to step S624.

[Step S623] The quantum circuit generation unit 133 converts a $C^L$-NOT gate that uses the qubits in $C_{tmp}$ as the control qubits and the i-th qubit in CA as the target qubit, into an equivalent circuit by the second conversion method using the first (L - 2) bits in $DA_{tmp}$ as dirty bits. The quantum circuit generation unit 133 outputs the equivalent circuit "$qc_{tmp2}$" obtained by the conversion.

[Step S624] The quantum circuit generation unit 133 generates a quantum circuit "$qc_{tmp1\_inv}$" by arranging the $C^2$-NOT gates in the quantum circuit "$qc_{tmp1}$" in reverse order.

[Step S625] The quantum circuit generation unit 133 adds "$qc_{tmp1}$", "$qc_{tmp2}$", and "$qc_{tmp1\_inv}$" to the equivalent circuit "circ".

(Step S626) The quantum circuit generation unit 133 removes the first $k_i$ elements listed in C, from C. The quantum circuit generation unit 133 adds the elements removed from C, to DA. Further, the quantum circuit generation unit 133 adds the i-th element (CA[i]) in CA to C.

[Step S627] The quantum circuit generation unit 133 outputs the equivalent circuit "circ".

By the process of FIGS. 27 and 28, as many quantum circuits ($C^{k\_1}$-NOT gate, ..., $C^{k\_c}$-NOT gate) as the number of clean bits are each converted into an equivalent circuit in which $C^2$-NOT gates are combined, and the converted equivalent circuits are added to the equivalent circuit "circ".

Next, a specific example of converting a $C^k$-NOT gate will be described.

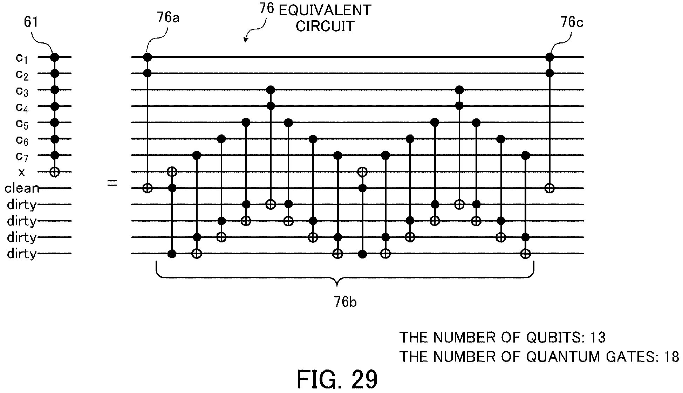

FIG. 29 illustrates an example of converting a $C^k$-NOT gate. Assume that the number of control qubits in a $C^k$-NOT gate 61 to be converted is "7" (k = 7), and one clean bit and four dirty bits are usable.

Inputs to the quantum gate conversion unit 130 are control qubits "C = {$c_1$, ..., $c_7$}", a target qubit x, tmpCleanBit-List "CA = {$ca_1$}", and tmpDirtyBitList "DA = {$da_1$, ..., $da_4$}". The quantum gate conversion management unit 131 first inputs "k = 7", "c = 1", and "d = 4" to the decomposition method determination unit 132.

In the case of "$k_1$ = 2" and "$k_2$ = 6", the left-hand side of the condition "($k_2$ - 2) ≤ (d + $k_1$)" in the end determination is "4" and the right-hand side thereof is "6". Therefore, the decomposition method determination unit 132 determines that the condition in the end determination is satisfied. The decomposition method determination unit 132 then outputs "$k_1$ = 2" and

"$k_2 = 6$".

The quantum gate conversion management unit 131 inputs "C", "CA", "DA", "$k_1 = 2$", and "$k_2 = 6$" to the quantum circuit generation unit 133 on the basis of the output result of the decomposition method determination unit 132. Then, the quantum circuit generation unit 133 first generates an empty equivalent circuit "qc = []".

Next, the quantum circuit generation unit 133 sets "i = 1", and adds a $C^2$-NOT gate 76a that uses "$c_1, c_2$" as the control qubits and $ca_1$ as the target qubit to "qc = []". At this time, the quantum circuit generation unit 133 updates the control qubits to "C = {$c_3, ..., c_7$}" and updates "tmpDirtyBitList" to "DA = {$da_1, ..., da_4, c_1, c_2$}". Further, the quantum circuit generation unit 133 generates a quantum circuit "$qc_{inv}$" by arranging the quantum gates included in "qc" in reverse order. In the example of FIG. 29, only a $C^2$-NOT gate 76c is included in "$qc_{inv}$".

The quantum circuit generation unit 133 converts the $C^6$-NOT gate that uses all the qubits of "C = {$c_3, ..., c_7$}" as the control qubits and x as the target qubit into an equivalent circuit 76b including only $C^2$-NOT gates by the second conversion method. At this time, the quantum circuit generation unit 133 sets "DA = {$da_1, ..., da_4, c_1, c_2$}" as dirty bits. The quantum circuit generation unit 133 adds the generated equivalent circuit 76b to "qc". Further, the quantum circuit generation unit 133 adds the $C^2$-NOT gate 76c in "$qc_{inv}$" to "qc".

As a result, an equivalent circuit 76 of the $C^2$-NOT gate 61 is output. The number of qubits in the output equivalent circuit 76 is "13", and the number of gates is "18". Compared with the first conversion method (the number of qubits being "17" and the number of quantum gates being "11") illustrated in FIG. 15, the fourth conversion method results in a small number of qubits. Compared with the second conversion method (the number of qubits being "13" and the number of quantum gates being "20") illustrated in FIG. 16, the fourth conversion method results in a small number of quantum gates. Compared with the third conversion method (the number of qubits being "13" and the number of quantum gates being "32") illustrated in FIG. 17, the fourth conversion method results in a small number of quantum gates.

As described above, the conversion by the fourth conversion method minimizes the number of quantum gates in the quantum circuit after conversion, under constraints where an increase in the number of qubits to be used is not possible. Reducing the number of quantum gates allows for a reduction in the computation time of the quantum computer 200.

Even in the case where the number of control qubits k in the $C^k$-NOT gate to be converted is larger, the application of the fourth conversion method in the same manner enables a reduction in the number of quantum gates after conversion, without increasing the number of qubits to be used. For example, consider the case of converting the $C^{12}$-NOT gate 73 illustrated in FIG. 21. The number of quantum gates in the equivalent circuit after conversion varies depending on the number of usable clean bits "c" and the number of usable dirty bits "d".

<Case of c = 0>

If $1 \leq d \leq (k-3)$, the $C^{12}$-NOT gate 73 is convertible into an equivalent circuit including 72 $C^2$-NOT gates by the third conversion method. If $d \geq (k-3)$, the $C^{12}$-NOT gate 73 is convertible into an equivalent circuit including 40 $C^2$-NOT gates by the second conversion method.

<Case of c = 1>

If d = 0, $k_1 = 6$ and $k_2 = 7$, then the number of $C^2$-NOT gates in the equivalent circuit is "52". If d = 1, $k_1 = 5$ and $k_2 = 8$, then the number of $C^2$-NOT gates in the equivalent circuit is "48". If d = 2, $k_1 = 5$ and $k_2 = 8$, then the number of $C^2$-NOT gates in the equivalent circuit is "48". If d = 3, $k_1 = 4$ and $k_2 = 9$, then the number of $C^2$-NOT gates in the equivalent circuit is "44". If d = 4, $k_1 = 4$ and $k_2 = 9$, then the number of $C^2$-NOT gates in the equivalent circuit is "44". If d = 5, $k_1 = 3$ and $k_2 = 10$, then the number of $C^2$-NOT gates in the equivalent circuit is "40". If d = 6, $k_1 = 3$ and $k_2 = 10$, then the number of $C^2$-NOT gates in the equivalent circuit is "40". If $d \geq 7$, $k_1 = 2$ and $k_2 = 11$, then the number of $C^2$-NOT gates in the equivalent circuit is "38".

<Case of c = 2>

If d = 0, 1, $k_1 = 3$, $k_2 = 3$, and $k_3 = 8$, then the number of $C^2$-NOT gates in the equivalent circuit is "38". If d = 2, 3, $k_1 = 3$, $k_2 = 2$, and $k_3 = 9$, then the number of $C^2$-NOT gates in the equivalent circuit is "36". If $d \geq 4$, $k_1 = 2$, $k_2 = 2$, and $k_3 = 10$, then the number of $C^2$-NOT gates in the equivalent circuit is "36".

<Case of c = 3>

If d = 0, $k_1 = 3$, $k_2 = 2$, $k_3 = 2$, and $k_4 = 8$, then the number of $C^2$-NOT gates in the equivalent circuit is "34". If $d \geq 1$, $k_1 = 2$, $k_2 = 2$, $k_3 = 2$, and $k_4 = 9$, then the number of $C^2$-NOT gates in the equivalent circuit is "34".

<Case of c = 4 to 9>

Regardless of the value of d, $k_1 = ... = k_c = 2$, and $k_{c+1} = (12 - c)$, then the number of $C^2$-NOT gates in the equivalent circuit is "40 - 2c".

<Case of c = 10>

By the first conversion method, the number of $C^2$-NOT gates in the equivalent circuit is "21".

As described above, the quantum gate conversion unit 130 is able to convert the $C^k$-NOT gate into a combination of as few $C^2$-NOT gates as possible.

[Other Embodiments]

In the second embodiment, quantum computation based on a quantum circuit is performed by the quantum computer 200. Alternatively, the quantum computation may be performed through quantum simulation using a classical computer. In this case, a classical computer capable of executing quantum simulation is used instead of the quantum computer 200. The classical computer 100 described in the second embodiment may execute the quantum simulation.

The second embodiment assumes that the quantum computer 200 is able to perform the gate operation of the $C^2$-NOT gate. However, there may be a case where the quantum computer 200 is unable to perform the gate operation of the $C^2$-NOT gate. In this case, the classical computer 100 converts the $C^2$-NOT gate into an equivalent circuit in which other basic quantum gates are combined. Even in this case, as described in the first and second embodiments, by converting a $C^k$-NOT gate into a small number of $C^2$-NOT gates in advance, it becomes possible to reduce the number of gates in the finally generated quantum circuit.

In the second embodiment, an equivalent circuit includes a quantum circuit to restore the original states of ancilla bits (clean bits or dirty bits). If it is known that it is not needed to restore the original states of the ancilla bits, the quantum circuit for restoring the original states may be excluded from the equivalent circuit. The case where the original states of the ancilla bits do not need to be restored is, for example, a case where the ancilla bits are not to be measured and the subsequent states of the ancilla bits do not affect any qubit to be measured. Omitting the quantum circuit for restoring the original states of the ancilla bits from the equivalent circuit reduces the number of quantum gates.

The foregoing merely illustrates the principles of the invention. Further, many modifications and variations are possible for those skilled in the art, and the present invention is not limited to the exact construction and application examples shown and described above, and all corresponding modifications and equivalents are deemed to be within the scope of the present invention as defined by the appended claims and their equivalents.

Reference Signs List

| | |
|---|---|
| 1 | First quantum circuit |
| 2 | First quantum gate |
| 2a | First qubit |
| 2b | Second qubit |
| 2c | Third qubit |
| 3 | Second quantum circuit |
| 3a | Second quantum gate |
| 3b | Third quantum gate |
| 3c | Fourth quantum gate |
| 4 | Fourth quantum circuit |
| 4a to 4c | Third quantum circuit |

**Claims**

**1.** A quantum circuit design support program that causes a computer to perform a process comprising:

extracting a first quantum gate from a first quantum circuit, the first quantum gate using k (k is an integer of 3 or more) first qubits as control qubits thereof and using one second qubit as a target qubit thereof, the first quantum gate being configured to flip a value of the target qubit in response to all the control qubits being 1;
identifying one or more third qubits that each have a predetermined value before a gate operation of the first quantum gate, from among qubits other than the first qubits and the second qubit;

determining a number of control qubits for a second quantum gate corresponding to the second qubit and a number of control qubits for each of one or more third quantum gates corresponding respectively to the one or more third qubits so that a sum of numbers of control qubits for the one or more third quantum gates and the number of control qubits for the second quantum gate satisfy a predetermined relationship; and

generating a second quantum circuit equivalent to the first quantum gate, the second quantum circuit including the one or more third quantum gates and the second quantum gate, the one or more third quantum gates each using first qubits equal in number to the determined number of control qubits as the control qubits thereof and using the corresponding one of the one or more third qubits as a target qubit thereof, the one or more third quantum gates each being configured to flip a value of the target qubit in response to all the control qubits being 1, the second quantum gate using a first qubit not used as the control qubits in the one or more third quantum gates and the one or more third qubits as the control qubits thereof and using the second qubit as a target qubit thereof, the second quantum gate being configured to flip a value of the target qubit in response to all the control qubits being 1.

2. The quantum circuit design support program according to claim 1, wherein the determining of the number of control qubits for the second quantum gate and the number of control qubits for each of the one or more third quantum gates includes applying, as the predetermined relationship, a relationship in which a predetermined value based on the number of control qubits for the second quantum gate is less than or equal to a sum of a number of fourth qubits and the numbers of control qubits for the one or more third quantum gates, the fourth qubits being other than the first qubits, the second qubit, and the one or more third qubits.

3. The quantum circuit design support program according to claim 1, wherein the determining of the number of control qubits for the second quantum gate and the number of control qubits for each of the one or more third quantum gates includes

setting an initial value for the number of control qubits for each of the one or more third quantum gates to 2 and setting an initial value for the number of control qubits for the second quantum gate to a value obtained by subtracting a number of third qubits from k, and

repeatedly increasing the number of control qubits for any one of the one or more third quantum gates and decreasing the number of control qubits for the second quantum gate by an amount corresponding to the increasing, until the predetermined relationship is satisfied.

4. The quantum circuit design support program according to claim 3, wherein the determining of the number of control qubits for the second quantum gate and the number of control qubits for each of the one or more third quantum gates includes

selecting one third quantum gate from the one or more third quantum gates corresponding respectively to the one or more third qubits in order,

repeating a process of increasing the number of control qubits for the selected third quantum gate by 1 and decreasing the number of control qubits for the second quantum gate by 1, until the number of control qubits for the selected third quantum gate satisfies a predetermined condition, and

selecting a next third quantum gate from the one or more third quantum gates in response to the predetermined condition being satisfied.

5. The quantum circuit design support program according to claim 1, wherein the generating of the second quantum circuit includes generating the second quantum circuit representing that gate operations of the one or more third quantum gates corresponding respectively to the one or more third qubits are performed, then a gate operation of the second quantum gate is performed, and then gate operations of one or more fourth quantum gates that perform same gate operations as the one or more third quantum gates, respectively, are performed in reverse order.

6. The quantum circuit design support program according to claim 5, wherein the process further includes

converting each of the second quantum gate, the one or more third quantum gates, and the one or more fourth quantum gates included in the second quantum circuit into a third quantum circuit equivalent thereto, the third quantum circuit being a combination of Toffoli gates, and

converting into a fourth quantum circuit by replacing the first quantum gate in the first quantum circuit with the third quantum circuits.

7. The quantum circuit design support program according to claim 6, wherein the converting of the first quantum gate into the fourth quantum circuit includes generating the third quantum circuit equivalent to the second quantum gate, using the first qubits used as the control qubits in the one or more third quantum gates and a fourth qubit as ancilla bits, the fourth qubit being other than the first qubits, the second qubit, and the one or more third qubits.

8. A quantum circuit design support method executed by a computer, the quantum circuit design support method comprising:

   extracting a first quantum gate from a first quantum circuit, the first quantum gate using k (k is an integer of 3 or more) first qubits as control qubits thereof and using one second qubit as a target qubit thereof, the first quantum gate being configured to flip a value of the target qubit in response to all the control qubits being 1;
   identifying one or more third qubits that each have a predetermined value before a gate operation of the first quantum gate, from among qubits other than the first qubits and the second qubit;
   determining a number of control qubits for a second quantum gate corresponding to the second qubit and a number of control qubits for each of one or more third quantum gates corresponding respectively to the one or more third qubits so that a sum of numbers of control qubits for the one or more third quantum gates and the number of control qubits for the second quantum gate satisfy a predetermined relationship; and
   generating a second quantum circuit equivalent to the first quantum gate, the second quantum circuit including the one or more third quantum gates and the second quantum gate, the one or more third quantum gates each using first qubits equal in number to the determined number of control qubits as the control qubits thereof and using the corresponding one of the one or more third qubits as a target qubit thereof, the one or more third quantum gates each being configured to flip a value of the target qubit in response to all the control qubits being 1, the second quantum gate using a first qubit not used as the control qubits in the one or more third quantum gates and the one or more third qubits as the control qubits thereof and using the second qubit as a target qubit thereof, the second quantum gate being configured to flip a value of the target qubit in response to all the control qubits being 1.

9. A quantum circuit design support apparatus comprising:
   a processing unit for

   extracting a first quantum gate from a first quantum circuit, the first quantum gate using k (k is an integer of 3 or more) first qubits as control qubits thereof and using one second qubit as a target qubit thereof, the first quantum gate being configured to flip a value of the target qubit in response to all the control qubits being 1,
   identifying one or more third qubits that each have a predetermined value before a gate operation of the first quantum gate, from among qubits other than the first qubits and the second qubit,
   determining a number of control qubits for a second quantum gate corresponding to the second qubit and a number of control qubits for each of one or more third quantum gates corresponding respectively to the one or more third qubits so that a sum of numbers of control qubits for the one or more third quantum gates and the number of control qubits for the second quantum gate satisfy a predetermined relationship, and
   generating a second quantum circuit equivalent to the first quantum gate, the second quantum circuit including the one or more third quantum gates and the second quantum gate, the one or more third quantum gates each using first qubits equal in number to the determined number of control qubits as the control qubits thereof and using the corresponding one of the one or more third qubits as a target qubit thereof, the one or more third quantum gates each being configured to flip a value of the target qubit in response to all the control qubits being 1, the second quantum gate using a first qubit not used as the control qubits in the one or more third quantum gates and the one or more third qubits as the control qubits thereof and using the second qubit as a target qubit thereof, the second quantum gate being configured to flip a value of the target qubit in response to all the control qubits being 1.

10 QUANTUM CIRCUIT DESIGN SUPPORT APPARATUS

11 STORAGE UNIT

1 FIRST QUANTUM CIRCUIT

12 PROCESSING UNIT

EXTRACT FIRST QUANTUM GATE

IDENTIFY THIRD QUBIT

DETERMINE THE NUMBER OF CONTROL QUBITS TO BE USED AFTER DECOMPOSITION
PREDETERMINED RELATIONSHIP: $k_{c+1} - 2 \leq d + \sum_{i=1}^{c} k_i$

GENERATE SECOND QUANTUM CIRCUIT   3 SECOND QUANTUM CIRCUIT

FIRST QUANTUM GATE 2

FIRST QUBIT 2a

SECOND QUBIT 2b

THIRD QUBIT 2c

$c_1$ $c_2$ $c_3$ $c_4$ $c_5$ $c_6$ $c_7$ $x$ $|0\rangle$

3b THIRD QUANTUM GATE

3a SECOND QUANTUM GATE

3c FOURTH QUANTUM GATE

CONVERT QUANTUM GATE

FIRST QUANTUM CIRCUIT 1

THIRD QUANTUM CIRCUIT

THIRD QUANTUM CIRCUIT

THIRD QUANTUM CIRCUIT

4a   4b   4c

4 FOURTH QUANTUM CIRCUIT

FIG. 1

FIG. 2

21 MONITOR

100 CLASSICAL
COMPUTER

104

101

CPU

GPU

22 KEYBOARD

102

RAM

105

INPUT
INTERFACE

23 MOUSE

103

HDD

106

OPTICAL
DRIVE
DEVICE

24 OPTICAL
DISC

109

NETWORK
INTERFACE

107

DEVICE
CONNEC-
TION
INTERFACE

25 MEMORY
DEVICE

100a
BUS

DEVICE
CONNEC-
TION
INTERFACE

108

26
MEMORY
READER-WRITER

27
MEMORY
CARD

20

NETWORK

200

QUANTUM
COMPUTER

FIG. 3

FIG. 4

FIG. 5

FIG. 6

49 QUANTUM CIRCUIT

FIG. 7

FIG. 8

31 TERMINAL

31a
QUANTUM
CIRCUIT
GENERATION
UNIT

100
CLASSICAL COMPUTER

120
CLEAN BIT
MANAGEMENT
UNIT

130
QUANTUM GATE
CONVERSION
UNIT

110
QUANTUM
COMPUTATION
MANAGEMENT
UNIT

200
QUANTUM
COMPUTER

FIG. 9

START

SET INFORMATION BASED ON QUANTUM CIRCUIT — S101

cleanBitList=I
dirtyBitList={1,···,n}−I
N=THE NUMBER OF QUANTUM GATES
i=1 — S102

S103 — i==N+1 ? — NO

YES

IS QC[i] A GATE TO BE CONVERTED? — S104 — YES

NO

CREATE tmpCleanBitList AND tmpDirtyBitList — S105

QUANTUM GATE CONVERSION (qc OUTPUT) — S106

QC[i]=qc — S107

SEND EXECUTION INSTRUCTION TO QUANTUM COMPUTER — S110

ACQUIRE QUANTUM COMPUTATION RESULT — S111

CLEAN BIT UPDATE — S108

$i \leftarrow i+1$ — S109

OUTPUT COMPUTATION RESULT — S112

END

FIG. 10

CLEAN BIT UPDATE

S201 — QC[i] = qc ?
- YES
- NO

S202 — IS QC[i] A SWAP GATE?
- YES
- NO

S203 — SWAP STATES OF QUBITS TO BE OPERATED

S204 — IS CONDITION THAT TARGET QUBIT j IN QC[i] IS INCLUDED IN cleanBitList AND NOT INCLUDED IN CI SATISFIED?
- YES
- NO

S205 — REMOVE j FROM cleanBitList AND ADD j TO dirtyBitList

S206 — IS CONDITION THAT TARGET QUBIT j IN QC[i] IS INCLUDED IN dirtyBitList AND INCLUDED IN CI SATISFIED?
- NO
- YES

S207 — REMOVE j FROM dirtyBitList AND ADD j TO cleanBitList

END

FIG. 11

48 QUANTUM CIRCUIT

CLEANING

THE NUMBER OF QUBITS : n=18
INITIAL STATE : I= {4, 6, 8, 10, 12, 14, 16}
CLEANING INFORMATION : CI=: {20,23,27,30,32,36,39}

cleanBitList= {4, 6, 8, 10, 12, 14, 16}
dirtyBitList= {1,2,3,5,7,9,11,13,15,17,18}
THE NUMBER OF GATES : N=40

FIG. 12

52  STATE TRANSITION TABLE

FIG. 13

|  | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|---|---|---|---|---|---|---|---|---|---|---|---|---|---|---|---|---|---|---|---|
| $x_1$ | C | C | C | C | C | C | C | C | C | C | C | C | C | C | C | C | C | C | C | C | C | C | C | C | C | C | C | C | C | C | C | C | C | C | C | C | C | C | C | C |
| $x_2$ | C | C | C | C | C | C | C | C | C | C | C | C | C | C | C | C | C | C | C | C | C | C | C | C | C | C | C | C | C | C | C | C | C | C | C | C | C | C | C | C |
| $q_0$ | C |  |  |  |  |  |  |  |  |  |  |  |  |  |  |  |  |  |  |  |  |  |  |  |  |  |  |  |  |  |  |  |  |  |  |  |  |  | C | t |
| $c_1$ | t |  |  | C |  |  |  |  |  |  |  |  |  |  |  |  |  |  |  |  |  |  |  |  |  |  |  |  |  |  |  |  |  | C |  |  |  | C | t | c |
| $q_1$ |  | C | t | C |  |  |  |  |  |  |  |  |  |  |  |  |  |  |  |  |  |  |  |  |  |  |  |  |  |  |  |  |  | C | t | C | t | t |  |  |
| $c_2$ | c | t |  | t | C |  |  |  |  |  |  |  |  |  |  |  |  |  |  |  |  |  |  |  |  |  |  |  |  |  |  | C | C | t |  | t | c | c | c | c |
| $q_2$ |  |  |  | C |  |  |  |  |  |  |  |  |  |  |  |  |  |  |  |  |  |  |  |  |  |  |  |  |  |  |  | C | C | t |  |  |  |  |  |  |
| $c_3$ | c | c | c | c | t | C |  |  |  |  |  |  |  |  |  |  |  |  |  |  |  |  |  |  |  |  |  |  |  |  |  | C | C | t | c | c | c | c | c | c |
| $q_3$ |  |  |  |  |  | C |  |  |  |  |  |  |  |  |  |  |  |  |  |  |  |  |  |  |  |  |  |  |  |  |  | C | t |  |  |  |  |  |  |  |
| $c_4$ | c | c | c | c | c | t |  |  | C |  |  |  |  |  |  |  |  |  |  |  |  |  |  |  |  |  |  | C |  |  | C | t |  |  |  |  |  |  |  |  |
| $q_4$ |  |  |  |  |  |  | C | t | C |  |  |  |  |  |  |  |  |  |  |  |  |  |  |  |  |  |  | C | t | C | t | t |  |  |  |  |  |  |  |  |
| $c_5$ | c | c | c | c | c | c | t |  | t | C |  |  |  |  |  |  |  |  |  |  |  |  |  |  |  | C | C | t |  | t | c | c | c | c | c | c | c | c | c | c |
| $q_5$ |  |  |  |  |  |  |  |  | C |  |  |  |  |  |  |  |  |  |  |  |  |  |  |  |  | C | t |  |  |  |  |  |  |  |  |  |  |  |  |  |
| $c_6$ | c | c | c | c | c | c | c | c | c | c | t |  | C |  |  |  |  | C |  |  |  | C | t | c | c | c | c | c | c | c | c | c | c | c | c | c | c | c | c | c |
| $q_6$ |  |  |  |  |  |  |  |  |  |  | C | t | C |  |  |  |  | C | t | C | t | t |  |  |  |  |  |  |  |  |  |  |  |  |  |  |  |  |  |  |
| $c_7$ | c | c | c | c | c | c | c | c | c | c | c | t |  | t |  |  | C | C | t |  | t | c | c | c | c | c | c | c | c | c | c | c | c | c | c | c | c | c | c | c |
| $q_7$ |  |  |  |  |  |  |  |  |  |  |  |  |  | C | t | C | t |  |  |  |  |  |  |  |  |  |  |  |  |  |  |  |  |  |  |  |  |  |  |  |
| $q_8$ |  |  |  |  |  |  |  |  |  |  |  |  |  | t |  | t |  |  |  |  |  |  |  |  |  |  |  |  |  |  |  |  |  |  |  |  |  |  |  |  |

CONVRESION
METHOD
APPLICATION
TABLE
60

THE NUMBER OF
DIRTY BITS: d

APPLICATION OF FOURTH
CONVERSION METHOD

SECOND
CONVERSION
METHOD
APPLICABLE

$d=k-2$

★

FIRST
CONVERSION
METHOD
APPLICABLE

FIRST OR
SECOND
CONVERSION
METHOD APPLICABLE
WITH ADDITIONAL
ANCILLA BITS

$d=1$ ☆

☆

$c=1$

$c=k-2$

THE NUMBER OF
CLEAN BITS: c

61

$c_1$
$c_2$
$c_3$
$c_4$
$c_5$
$c_6$
$c_7$
x
clean
dirty
dirty
dirty
dirty

THIRD CONVERSION
METHOD APPLICABLE

FIG. 14

THE NUMBER OF QUBITS: 13 + 4
THE NUMBER OF QUANTUM GATES: 11

FIG. 15

61

63 EQUIVALENT
CIRCUIT

THE NUMBER OF QUBITS: 13
THE NUMBER OF QUANTUM GATES: 20

FIG. 16

FIG. 17

FIG. 18

FIG. 19

FIG. 20

FIG. 21

FIG. 22

$C^k$-NOT GATE (CONTROL QUBITS $C=\{c_1,\cdots,c_k\}$ AND TARGET QUBIT x)
tmpCleanBitList: $CA=\{ca_1,\cdots,ca_c\}$ (PROVIDED THAT $1 \leq c \leq k-3$)
tmpDirtyBitList: $DA=\{da_1,\cdots,da_d\}$

FIG. 23

QUANTUM GATE
CONVERSION
START

S301

c=0 AND d≥1 —— YES ——

NO

S302

GENERATE EQUIVALENT
CIRCUIT (qc) BY THIRD
CONVERSION METHOD

S303

c≥k−2 —— YES ——

NO

S305

DECOMPOSITION
METHOD
DETERMINATION

S306

EQUIVALENT CIRCUIT
(qc) GENERATION
USING FOURTH
CONVERSION METHOD

S304

GENERATE EQUIVALENT
CIRCUIT (qc) BY FIRST
CONVERSION METHOD

S307

OUTPUT qc

END

FIG. 24

DECOMPOSITION
METHOD
DETERMINATION
START

S401

$$k_1 = \cdots = k_c = 2,$$
$$k_{c+1} = k - \sum_{i=1}^{c}(k_i - 1)$$

S402

$j = 1$

S403

$k_{c+1} - 2 \leq d + \sum_{i=1}^{c} k_i ?$

NO

YES

S407

OUTPUT $k_1, \cdots, k_{c+1}$

S404

$k_j \leftarrow k_j + 1,\ k_{c+1} \leftarrow k_{c+1} - 1$

S405

$k_j \geq c - j + 2 ?$

NO

YES

S406

$j \leftarrow (j \bmod c) + 1$

END

FIG. 25

**FIG. 26**

$C^{k\_i}$–NOT GATE
CONVERSION
START

S601
circ=[ ]

S602
$k_i$=2?

YES → S603
ADD $C^2$–NOT THAT USES C[0] AND C[1] AS CONTROL QUBITS AND CA[i] AS TARGET QUBIT, TO circ

S604
REMOVE C[0] AND C[1] FROM LIST C AND ADD THEN TO DA

S605
ADD CA[i] TO DA

S606
ADD CA[i] TO C

B

NO

S607
CREATE LIST $C_{tmp}$ LISTING FIRST $k_i$ FROM C

S608
$qc_{tmp1}$=[ ]

S609
$DA_{tmp} \leftarrow C \setminus C_{tmp}$

S610
p=min{$k_i$−2, c−i}

S611
j=i=1

S612
j≤i+p?

YES → S613
ADD $C^2$–NOT GATE THAT USES $C_{tmp}$[0] AND $C_{tmp}$[1] AS CONTROL QUBITS AND CA[j] AS TARGET QUBIT, TO $qc_{tmp1}$

S614
ADD $C_{tmp}$[0] AND $C_{tmp}$[1] TO $DA_{tmp}$

S615
REMOVE $C_{tmp}$[0] AND $C_{tmp}$[1] FROM LIST $C_{tmp}$

S616
ADD CA[j] TO $C_{tmp}$

S617
j←j+1

NO

S618
L←$k_i$−p

A

FIG. 27

Ⓐ

◇ L=2? ⟩ S621     NO

YES

SET $C^2$-NOT GATE THAT USES $C_{tmp}[0]$ AND $C_{tmp}[1]$ AS CONTROL QUBITS AND CA[i] AS TARGET QUBIT, AS $qc_{tmp2}$   S622

CONVERT $C^L$-NOT GATE THAT USES $C_{tmp}$ AS CONTROL QUBITS AND CA[i] AS TARGET QUBIT, INTO $qc_{tmp2}$ BY SECOND CONVERSION METHOD USING FIRST (L − 2) IN $DA_{tmp}$ AS DIRTY BITS   S623

GENERATE QUANTUM CIRCUIT $qc_{tmp1\_inv}$ BY ARRANGING $C^2$-NOT IN $qc_{tmp1}$ IN REVERSE ORDER   S624

ADD $qc_{tmp1}$, $qc_{tmp2}$, AND $qc_{tmp1\_inv}$ TO circ   S625

REMOVE FIRST $k_i$ ELEMETNS IN C, FROM C, ADD THEM TO DA, AND ADD CA[i] TO C   S626

Ⓑ

OUTPUT circ   S627

END

FIG. 28

76 EQUIVALENT CIRCUIT

THE NUMBER OF QUBITS: 13
THE NUMBER OF QUANTUM GATES: 18

FIG. 29

## INTERNATIONAL SEARCH REPORT

| International application No. |
|---|
| **PCT/JP2023/001369** |

| A. CLASSIFICATION OF SUBJECT MATTER |
|---|
| ***G06N 10/40***(2022.01)i<br>FI: G06N10/40 |

According to International Patent Classification (IPC) or to both national classification and IPC

| B. FIELDS SEARCHED |
|---|
| Minimum documentation searched (classification system followed by classification symbols)<br>    G06N10/00-10/80 |

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | KUNIHIRO, N. Practical running time of factoring by quantum circuits. ERATO CONFERENCE ON QUANTUM INFORMATION SCIENCE 2003 [online]. 2003, pp. 1-2, [retrieved on 04 April 2023], Retrieved from the Internet: <URL: http://aqis-conf.org/archives/eqis03/program/index.html><br>    section 3.1 | 1-9 |
| A | US 2021/0264309 A1 (IONQ, INC.) 26 August 2021 (2021-08-26)<br>    paragraphs [0046]-[0048], fig. 3(b) | 1-9 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 April 2023** | **11 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
**Information on patent family members**

International application No.

**PCT/JP2023/001369**

| Patent document cited in search report | Publication date (day/month/year) | Patent family member(s) | Publication date (day/month/year) |
|---|---|---|---|
| US 2021/0264309 A1 | 26 August 2021 | CN 115244549 A<br>WO 2021/168096 A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022530389 A
- US 20200134501
- JP 2014503890 A